# EUROPEAN PATENT APPLICATION

(11) **EP 4 401 311 A1**
(43) Date of publication of application: **17.07.2024**
(21) Application number: 22946033.2
(22) Date of filing: 22.12.2022
(51) Int. Cl.: H03H 9/02

(54) **BULK ACOUSTIC WAVE RESONATOR, RELATED DEVICES, AND PREPARATION METHOD FOR BULK ACOUSTIC WAVE RESONATOR**

(30) Priority: 25.11.2022 CN 202211489903
(71) Applicant: JWL (Zhejiang) Semiconductor Co., Ltd., Huzhou, Zhejiang 313000 (CN)
(72) Inventor: LI, Linping, Huzhou, Zhejiang 313000 (CN)
(74) Representative: Kolster Oy Ab
(86) International application number: PCT/CN2022/141071
(87) International publication number: WO 2024/108710

(57) **Abstract**

A bulk acoustic resonator, related devices including a resonator assembly, a filter, and an electronic device, and a method for manufacturing a bulk acoustic wave resonator are provided. The bulk acoustic resonator includes a substrate and an acoustic reflection component, a first electrode, a piezoelectric layer, and a second electrode that are sequentially stacked on a surface of the substrate. A first gap is provided between the first electrode and the piezoelectric layer. A second gap is provided between the piezoelectric layer and a second electrode connection part of the second electrode in addition to a part of the second electrode located within the effective resonance region. An initial end of the first gap coincides with a terminal end of the effective resonance region, a terminal end of the second gap is located at an outer side of the terminal end of the first electrode, and the first gap interlaces and overlaps with the second gap in a direction perpendicular to a plane where the substrate is located. Such double-layer gap structure can reduce the parasitic oscillation in the non-effective resonance region, reflect the transverse waves, reduce the leakage of the transverse waves, improve the Q factor of the device. In addition, the electrode layers and the piezoelectric layer are more stable due to the mutual support at the two gaps.

## Description

This application claims the priority to Chinese Patent Application No. 202211489903.1, titled "BULK ACOUSTIC RESONATOR AND RELATED DEVICE, AND METHOD FOR MANUFACTURING BULK ACOUSTIC RESONATOR", filed on November 25, 2022 with the China National Intellectual Property Administration, which is incorporated herein by reference in its entirety.

### FIELD

The present disclosure relates to technical field of semiconductors, and in particular to a bulk acoustic resonator, a method for manufacturing a bulk acoustic resonator, a filter and an electronic device.

### BACKGROUND

A basic structure of a bulk acoustic resonator is a "sandwich" structure. Such sandwich-structure is formed by a piezoelectric layer and metal electrodes arranged on an upper surface and a lower surface of the piezoelectric layer. A voltage is applied to the metal electrodes on the upper surface and the lower surface of the piezoelectric layer, to cause the piezoelectric layer to generate an alternating electric field. The piezoelectric layer is deformed due to the reverse piezoelectric effect of the piezoelectric layer, which is represented as vibration of phonons from a micro perspective and as acoustic waves from a macro perspective. The acoustic waves are bulk acoustic waves (BAWs) inside the piezoelectric layer. Though such process, the electrical energy is converted into mechanical energy in a form of the acoustic waves. A transmission path of the bulk acoustic wave is equal to a total thickness of the upper electrode, the lower electrode and the piezoelectric layer. In a case that a wavelength of the bulk acoustic wave and the length of the transmission path meet a certain relationship, a standing wave oscillation is formed. In this case, the signal resonates inside the material, where equivalent impedance of the device reaches an extremum.

In general, an acoustic reflection component is arranged between a substrate and a bottom electrode, in order to suppress the leakage of acoustic energy, so that an overlap between the acoustic reflection component, the bottom electrode, the piezoelectric layer, and a top electrode is an effective resonance region. According to a relationship between a polarization direction and a propagation direction of the bulk acoustic wave, the bulk acoustic wave may be in a longitudinal mode or a transverse mode. The longitudinal mode is the fundamental resonance and corresponds to longitudinal waves propagating in a direction vertical to the piezoelectric layer. The longitudinal waves exhibit periodic back-and-forth motion between the upper electrode and the lower electrode, which are reflected back to the effective resonance region at a boundary of the bottom electrode and the acoustic reflection component to avoid a loss in acoustic energy. The longitudinal wave is presented as a same phase at all positions of the upper electrode and the lower electrode. The transverse mode is a parasitic mode. While generating the longitudinal waves, the resonator also generates the transverse waves. The transverse wave horizontally propagates in a direction parallel to the piezoelectric layer. The transverse wave oscillation causes energy leakage at a boundary of an effective region of the resonator, which results in an energy loss so as to compromise a quality factor (Q factor) of the device.

In conventional technology, a top electrode of the bulk acoustic resonator is required to extend outwards to be connected to another resonator or other electrical component. However, an outward connection part of the top electrode is usually overlapped with a region of the bottom electrode and the piezoelectric layer outside the boundary of the acoustic reflection component, causing resonance to generate in a non-effective resonance region, resulting in parasitic oscillation. In comparison with the air, the acoustic waves tend to propagate in a solid medium. As an end of the top electrode is connected outwards to form the top electrode connection part, while other ends of the top electrode are usually air, the acoustic waves tend to propagate towards the top electrode connection part, resulting in a large loss of the acoustic wave at the top electrode connection part. In addition, a crystal orientation of the piezoelectric layer grown in the non-effective resonance region is generally far from satisfaction, and the generated resonance may compromise the effective resonance region, resulting in poor performance of the resonator.

In view of this, it is of significant concern on how to reduce loss in the acoustic energy of the bulk acoustic resonator and improve the Q factor.

### SUMMARY

In order to solve the above technical problem, a bulk acoustic resonator, a method for manufacturing a bulk acoustic resonator, a resonator assembly, a filter and an electronic device are provided according to embodiments of the present disclosure, to reduce a loss in acoustic energy of the bulk acoustic resonator and improve the Q factor of the bulk acoustic resonator.

To this end, a bulk acoustic resonator is provided according to a first aspect of the present disclosure. The bulk acoustic resonator includes:
a substrate; and
a first electrode, a piezoelectric layer, and a second electrode that are sequentially stacked on a surface of the substrate;
wherein the piezoelectric layer extends beyond a terminal end of the first electrode, an acoustic reflection component is arranged between the first electrode and the substrate, and an overlapping part of the acoustic reflection component, the first electrode, the piezoelectric layer, and the second electrode is configured as an effective resonance region;
a first gap is provided between the first electrode and the piezoelectric layer, and an initial end of the first gap coincides with a terminal end of the effective resonance region; in a first direction, an upper surface of the first gap is not higher than an upper surface of a part of the first electrode within the effective resonance region; in addition to a part of the second electrode located within the effective resonance region, the second electrode further includes a second electrode connection part, a second gap is provided between the second electrode connection part and the piezoelectric layer, a terminal end of the second gap is located at outer side of the terminal end of the first electrode, a projection of the second gap in the first direction interlaces and overlaps with a projection of the first gap in the first direction, and the first direction is perpendicular to a plane where the substrate is located.

In an embodiment, a width of an overlapping region between the projection of the first gap in the first direction and the projection of the second gap in the first direction is greater than or equal to half of a width of the first gap.

In an embodiment, in the first direction, a distance from an upper end to a lower end of a cross-section of the second gap ranges from 10nm to 200nm, including endpoints.

In an embodiment, in the first direction, a distance from an upper end to a lower end of a cross-section of the second gap ranges from 30nm to 50nm, including endpoints.

In an embodiment, the upper surface of the first gap in the first direction is arc-shaped, inclined, stepped, or horizontal.

In an embodiment, the first electrode protrudes upwards from the surface of the substrate, the acoustic reflection component is formed between a protrusion of the first electrode and the surface of the substrate, and the protrusion of the first electrode includes a first sloping region with an inclined angle relative to the surface of the substrate; and the initial end of the first gap coincides with an initial end of the first sloping region, and the terminal end of the first gap extends beyond a terminal end of the first sloping region.

In an embodiment, the first electrode includes a first thinning region, a thickness of the first thinning region is less than a thickness of the part of the first electrode within the effective resonance region, the first gap is formed between at least a part of the first thinning region and the piezoelectric layer, and an initial end of the first thinning region coincides with the initial end of the first gap.

In an embodiment, an upper surface of the first thinning region in the first direction is arc-shaped, inclined, stepped, or groove-shaped.

In an embodiment, a terminal end of the first thinning region coincides with the terminal end of the first electrode; or the terminal end of the first thinning region is located at an inner side of the terminal end of the first electrode.

In an embodiment, a terminal end of the first thinning region is located at an inner side of the terminal end of the first electrode, and a horizontal distance between the initial end of the first thinning region and the terminal end of the first electrode is no more than 3µm.

In an embodiment, at least one third gap is further provided between the first electrode and the piezoelectric layer, the at least one third gap is located on one or more sides of the effective resonance region away from the first gap, and a terminal end of the second electrode away from the second electrode connection part does not extend beyond a terminal end of the third gap; and in the first direction, an upper surface of the third gap is not higher than the upper surface of the part of the first electrode within the effective resonance region.

In an embodiment, the first electrode includes a second thinning region, and a thickness of the second thinning region is less than a thickness of the part of the first electrode within the effective resonance region, so that the third gap is formed between the second thinning region and the piezoelectric layer.

In an embodiment, the third gap is formed by the first gap surrounding the effective resonance region, and the third gap is in communication with the first gap; or the third gap is not in communication with the first gap.

In an embodiment, a recess is formed by the first electrode recessing towards the acoustic reflection component, and the first gap is formed between the recess and the piezoelectric layer.

In an embodiment, a sidewall of the recess is directly in contact with a sidewall of the acoustic reflection component; or a space is provided between the sidewall of the recess and the sidewall of the acoustic reflection component.

In an embodiment, a horizontal distance between the initial end of the first gap and a terminal end of the acoustic reflection component is no more than 3µm.

In an embodiment, an upper surface of the second gap in the first direction is arc-shaped, inclined, stepped, arch-shaped or groove-shaped.

In an embodiment, the piezoelectric layer has a constant thickness in the first direction.

A resonator assembly is further provided according to a second aspect of the present disclosure. The resonator assembly at least includes a first resonator, an electrical component and a connection structure. The first resonator is any one bulk acoustic resonator described above. Two ends of the connection structure are connected to a second electrode connection part of the first resonator and the electrical component, respectively.

In an embodiment, in the first direction, an upper surface of the connection structure aligns with an upper surface of a part of the second electrode within an effective resonance region of the first resonator, and a fourth gap is provided between the connection structure and the piezoelectric layer.

In an embodiment, the second electrode connection part of the first resonator is connected to the electrical component through the connection structure and a connection member, the piezoelectric layer is provided with a through hole running through the piezoelectric layer, and the connection member is located in the through hole and connected to the electrical component; in the first direction, the connection member further extends from the through hole to the upper surface of the piezoelectric layer.

In an embodiment, the electrical component includes a resonator, an inductor, a capacitor, or a pad.

A method for manufacturing a bulk acoustic resonator is further provided according to a third aspect of the present disclosure. The method includes:
providing a substrate with a first sacrificial layer or a Bragg reflector;
forming a first electrode on the substrate, so that the first sacrificial layer or the Bragg reflector is arranged between the substrate and the first electrode;
forming a piezoelectric layer on a side of the first electrode away from the substrate, and forming a second sacrificial layer between the first electrode and the piezoelectric layer;
forming a second electrode on a side of the piezoelectric layer away from the substrate, and forming a third sacrificial layer between the piezoelectric layer and the second electrode; and
releasing the first sacrificial layer to form a cavity, which serves as an acoustic reflection component, or directly using the Bragg reflector as the acoustic reflection component, and releasing the second sacrificial layer and the third sacrificial layer, to form a first gap between the first electrode and the piezoelectric layer, and form a second gap between the piezoelectric layer and a second electrode connection part of the second electrode in addition to a part of the second electrode located within an effective resonance region;
wherein an overlapping part of the acoustic reflection component, the first electrode, the piezoelectric layer, and the second electrode is configured as the effective resonance region, an initial end of the first gap coincides with a terminal end of the effective resonance region; in a first direction, an upper surface of the first gap is not higher than an upper surface of a part of the first electrode within the effective resonance region, a terminal end of the second gap is located at an outer side of a terminal end of the first electrode, a projection of the second gap in the first direction interlaces and overlaps with a projection of the first gap in the first direction; and the first direction is perpendicular to the plane where the substrate is located.

A filter is further provided according to a fourth aspect of the present disclosure. The filter includes any one bulk acoustic resonator described above, or any one resonator assembly described above.

An electronic device is further provided according to a fifth aspect of the present disclosure. The electronic device includes any one bulk acoustic resonator described above, or any one resonator assembly described above.

Compared with conventional technology, the above technical solutions are at least of advantages as follows.

The bulk acoustic resonator according to the embodiments of the present disclosure includes a substrate and a first electrode, a piezoelectric layer, and a second electrode that are sequentially stacked on a surface of the substrate. The piezoelectric layer extends beyond a terminal end of the first electrode, an acoustic reflection component is arranged between the first electrode and the substrate, and an overlapping part of the acoustic reflection component, the first electrode, the piezoelectric layer, and the second electrode is configured as an effective resonance region. A first gap is provided between the first electrode and the piezoelectric layer. In addition to a part of the second electrode located within the effective resonance region, the second electrode further includes a second electrode connection part, a second gap is provided between the second electrode connection part and the piezoelectric layer. An initial end of the first gap coincides with a terminal end of the effective resonance region, and a terminal end of the second gap is located at an outer side of the terminal end of the first electrode. In other words, from the terminal end of the effective resonance region to the outer side of the terminal end of the first electrode in a direction away from the effective resonance region, the first electrode is first separated from the piezoelectric layer by the first gap, and then the piezoelectric layer is separated from the second electrode connection part by the second gap. In such case, a double-layer gap structure including the first gap and the second gap is arranged at the boundary of the effective resonance region, so that the first electrode, the piezoelectric layer and the second electrode at the boundary of the effective resonance region are completely separated from each other, and the second electrode connection part located outside the effective resonance region is not overlapped with the piezoelectric layer and the first electrode, which eliminates the parasitic oscillation in the non-effective resonance region.

In addition, the first gap between the first electrode and the piezoelectric layer forms a morphological change in the first electrode, the first gap, and the piezoelectric layer. The second gap between the piezoelectric layer and the second electrode connection part forms a morphological change in the piezoelectric layer, the second gap, and the second electrode connection part. In addition, an acoustic impedance change occurs in both the first gap and the second gap, to reflect the transverse waves, reduce a leakage of the transverse wave, and improve the Q factor of the bulk acoustic resonator. Further, the double-layer gap structure including the first gap and the second gap is arranged at the boundary of the effective resonance region, forming the double reflection structure, which enhances the effect of reflecting the transverse waves. In this way, it enables total reflection at the boundary of the effective resonance region AA, reducing the loss in the acoustic energy. In addition, it significantly confines the acoustic wave energy to resonate in a longitudinal mode. Particularly, when the two gaps are filled with air, the acoustic waves at an air interface exhibit high reflection efficiency, effectively reducing acoustic energy loss.

Moreover, in the bulk acoustic resonator according to the embodiments of the present disclosure, the first electrode, the piezoelectric layer, and the second electrode are separated from each other by the gaps at the boundary of the effective resonance region and are relatively free, avoiding a stress transfer phenomenon caused by the electrode layers being in direct contact with the piezoelectric layer at the boundary of the effective resonance region, so that the thin film stress between the electrode layers and piezoelectric layer can be effectively reduced, so as to reduce the stress accumulation at the boundary of the effective resonance region. In addition, the effect of reducing the stress transfer through the gap filled with the air is better than the effect of reducing the stress transfer through the gap filled with the dielectric material. The electrode layers and the piezoelectric layer are in a stress balance state due to the mutual support at the two gaps, thereby forming a strong and stable structure. Especially, in the direction perpendicular to the plane where the substrate is located (that is, the first direction), the upper surface of the first gap is not higher than the upper surface of the part of the first electrode within the effective resonance region, so that a morphological of the piezoelectric layer is steadily transitioned to the surface of the substrate, reducing the stress of the piezoelectric layer, thereby further enhancing the reliability of the structure of the bulk acoustic resonator.

Furthermore, the conventional bulk acoustic resonator tends to deform and exhibit poor mechanical stability when exposed to external forces or temperature fluctuations. Currently, a single gap is arranged at the boundary of the effective resonance region to reflect transverse waves. However, this approach not only yields limited effectiveness in reflecting transverse waves but also poses challenges, i.e., the single air gap is prone to fractures or collapses due to its large size, ultimately compromising the overall structural stability of the bulk acoustic resonator. Hence, in the bulk acoustic resonator according to the embodiments of the present disclosure, by arranging the projection of the first gap K1 in the first direction Z interlaces and overlaps with the projection of the second gap K2 in the first direction Z, it reduces the size of the single gap, preventing it from being fractured or collapsed due to excessively long or high. Additionally, the double-layer gap structure enhances the length of the gap in the horizontal direction, enabling the bulk acoustic resonator to withstand structural deformations and ensuring excellent mechanical stability.

The other objectives and the advantages of the present disclosure are described in detail in the following embodiments in conjunction with the drawings.

### BRIEF DESCRIPTION OF THE DRAWINGS

For clearer illustration of the technical solutions according to embodiments of the present disclosure or conventional techniques, hereinafter are briefly described the drawings to be applied in embodiments of the present disclosure or conventional techniques. Apparently, the drawings in the following descriptions are only some embodiments of the present disclosure, and other drawings may be obtained by those ordinary skilled in the art based on the provided drawings without creative efforts.
Figure 1 is a schematic cross-sectional view of a bulk acoustic resonator in conventional technology;
Figure 2 is a schematic cross-sectional view of a bulk acoustic resonator according to an embodiment of the present disclosure;
Figure 3 is a schematic cross-sectional view of a bulk acoustic resonator according to another embodiment of the present disclosure;
Figure 4 is a schematic cross-sectional view of a bulk acoustic resonator according to still another embodiment of the present disclosure;
Figure 5 is a schematic cross-sectional view of a bulk acoustic resonator according to yet another embodiment of the present disclosure;
Figure 6 is a schematic cross-sectional view of a bulk acoustic resonator according to still another embodiment of the present disclosure;
Figure 7 is a schematic cross-sectional view of a bulk acoustic resonator according to yet another embodiment of the present disclosure;
Figure 8 is a schematic cross-sectional view of a bulk acoustic resonator according to still another embodiment of the present disclosure;
Figure 9 is a schematic cross-sectional view of a bulk acoustic resonator according to yet another embodiment of the present disclosure;
Figure 10 is a schematic cross-sectional view of a bulk acoustic resonator according to still another embodiment of the present disclosure;
Figure 11 is a schematic cross-sectional view of a bulk acoustic resonator according to yet another embodiment of the present disclosure;
Figure 12 is a schematic cross-sectional view of a bulk acoustic resonator according to still another embodiment of the present disclosure;
Figure 13 is a schematic cross-sectional view of a bulk acoustic resonator according to yet another embodiment of the present disclosure;
Figure 14 is graphs of impedance-frequency relationships of a bulk acoustic resonator according to an embodiment of the present disclosure compared with a conventional sandwich-structure bulk acoustic resonator;
Figure 15 is a schematic cross-sectional view of a bulk acoustic resonator according to still another embodiment of the present disclosure;
Figure 16 is a schematic cross-sectional view of a bulk acoustic resonator according to yet another embodiment of the present disclosure; and
Figures 17(a) to 17(h) are schematic structural diagrams of respective device structures corresponding to respective process steps in a method for manufacturing a bulk acoustic resonator according to an embodiment of the present disclosure.

### DETAILED DESCRIPTION

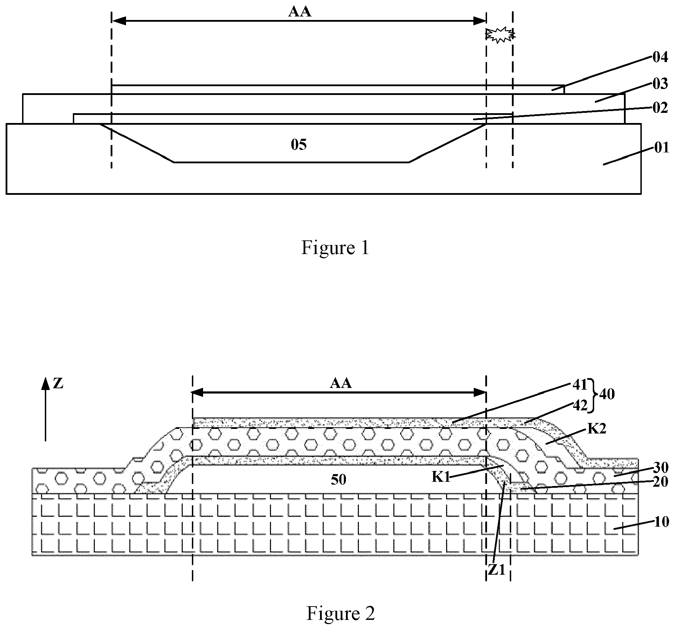

Figure 1 is a schematic structural diagram of a bulk acoustic resonator in conventional technology. As shown in Figure 1, the bulk acoustic resonator includes a substrate 01, a bottom electrode 02, a piezoelectric layer 03, and a top electrode 04 that are arranged on the substrate. An acoustic reflection component, i.e., cavity 05, and is arranged between the substrate 01 and the bottom electrode 02. As described in the background part, the conventional bulk acoustic resonator has the shortcomings as follows.
1. A projection of an outward connection part of the top electrode 04 above the substrate 01, a projection of the piezoelectric layer 03 and a projection of the bottom electrode 02 in a vertical direction are overlapped with each other, which may easily form parasitic oscillation and impact an effective resonance region AA, resulting in a large loss of the acoustic waves at the top electrode connection part.
2. The transverse waves leak at a boundary of the effective resonance region AA, resulting in the loss in energy and impacting a Q factor of the device.

Hence, it is of significant concern how to reduce loss in the acoustic energy of the bulk acoustic resonator and to improve the Q factor.

Although it has been reported that a gap is arranged at the boundary of the effective resonance region of the bulk acoustic resonator in conventional technology to reflect transverse waves and reduce the loss in the acoustic energy of the bulk acoustic resonator, thereby improving the Q factor of the bulk acoustic resonator, the inventors found that the gap is normally a single air gap. The single air gap not only has a limited effect on reflecting the transverse waves but also has a large size. As a result, it is more likely to be fractured or collapsed, reducing the stability of an overall structure of the bulk acoustic resonator. In addition, the single air gap with the large size may cause a significant morphological change in the piezoelectric layer, resulting in stress accumulation of the bulk acoustic resonator at the boundary of the effective resonance region. This further reduces the stability of the overall structural of the bulk acoustic resonator.

The inventors further found that the conventional bulk acoustic resonator is deformed when exposed to external forces or temperature fluctuations, reducing mechanical stability of the device. However, the single air gap with the large size may further reduce the stability of the structure of the bulk acoustic resonator. Especially at high frequencies, given that the electrode has a thin thickness ranging from 50nm to 100nm and the size of the air gap is too large, this can lead to deformation and fracture of the top electrode at the gap, resulting in device failure.

In view of this, a bulk acoustic resonator is provided according to an embodiment of the present disclosure. Figures 2 to 12 are schematic cross-sectional views of a bulk acoustic resonator according to different embodiments of the present disclosure. As shown in Figures 2 to 12, the bulk acoustic resonator includes: a substrate 10; a first electrode 20, a piezoelectric layer 30, and a second electrode 40 are sequentially stacked on a surface of the substrate 10; wherein the piezoelectric layer 30 extends beyond a terminal end of the first electrode 20; an acoustic reflection component 50 is arranged between the first electrode 20 and the substrate 10; an overlapping part of the acoustic reflection component 50, the first electrode 20, the piezoelectric layer 30, and the second electrode 40 is configured as an effective resonance region AA; a first gap K1 is provided between the first electrode 20 and the piezoelectric layer 30, an initial end of the first gap K1 overlaps with a terminal end of the effective resonance region AA; in a first direction Z, an upper surface of the first gap K1 is not higher than an upper surface of a part of the first electrode 20 within the effective resonance region AA; in addition to a part 41 of the second electrode 40 located within the effective resonance region AA, the second electrode 40 further includes a second electrode connection part 42; a second gap K2 is provided between the second electrode connection part 42 and the piezoelectric layer 30, a terminal end of the second gap K2 is located at outer side of the terminal end of the first electrode 20; a projection of the second gap K2 in the first direction Z interlaces and overlaps with the projection of the first gap K1 in the first direction Z. The first direction Z is perpendicular to a plane where the substrate 10 is located.

In the embodiment of the present disclosure, the overlapping part of the acoustic reflection component 50, the first electrode 20, the piezoelectric layer 30 and the second electrode 40 is the effective resonance region AA. The overlapping part of the acoustic reflection component 50, the first electrode 20, the piezoelectric layer 30 and the second electrode 40 is where projections of the acoustic reflection component 50, the first electrode 20, the piezoelectric layer 30 and the second electrode 40 in the first direction Z overlap, and it includes the part where adjacent layers are in contact with each other.

In the embodiment of the present disclosure, the "initial end" is an end close to the effective resonance region AA, and the "terminal end" is an end away from the effective resonance region AA. The initial end of the first gap K1 coincides with the terminal end of the effective resonance region AA, and thus the terminal end of the first gap K1 is located outside the terminal end of the effective resonance region AA.

In the embodiment of the present disclosure, since the first gap K1 is located between the first electrode 20 and the piezoelectric layer 30, the upper surface of the first gap K1 is an interface between the first gap K1 and the piezoelectric layer 30. In the first direction Z, the upper surface of the first gap K1 is not higher than the upper surface of the part of the first electrode 20 within the effective resonance region AA. In other words, the piezoelectric layer 30 extends downwards from the terminal end of the effective resonance region AA to smoothly transition to the surface of the substrate 10, so that the piezoelectric layer 30 has a small morphological change, fewer growth defects, and high growth quality.

It should be noted that the terminal end of the first gap K1 may be located at the inner side of the terminal end of the first electrode 20, may coincide with the terminal end of the first electrode 20, or may be located at the outer side of the terminal end of the first electrode 20. Therefore, a lower surface of the first gap K1 may be an interface between the first gap K1 and the first electrode 20, or an interface between the first gap K1 and the first electrode 20 as well as an interface between the first gap K1 and the surface of the substrate 10, which depends on the actual situation.

In the embodiment of the present disclosure, in the first direction Z, the upper surface of the first gap K1 may be arc-shaped, inclined, stepped, or horizontal. For example, in a case that the upper surface of the first gap K1 is arc-shaped, the interface between the piezoelectric layer 30 and the first gap K1 is arc-shaped, which indicates that the piezoelectric layer 30 grows on an arc-shaped surface, where the growing piezoelectric layer 30 gradually transitions to the surface of the substrate 10 in an arc shape. This results in minimal morphological changes in the piezoelectric layer 30 with fewer growth defects and high growth quality. Consequently, the piezoelectric layer 30 exhibits high piezoelectric performance.

In the embodiment of the present disclosure, the second gap K2 is located between the piezoelectric layer 30 and the second electrode connection part 42. In this case, an upper surface of the second gap K2 is an interface between the second gap K2 and the second electrode connection part 42, and a lower surface of the second gap K2 is an interface between the second gap K2 and the piezoelectric layer 30.

In an embodiment of the present disclosure, in the first direction Z, the upper surface of the second gap K2 may be arc-shaped, inclined, stepped, arch-shaped, groove-shaped, which depends on the actual situation.

It should be noted that whether the upper surface of the second gap K2 is higher than an upper surface of a part of the piezoelectric layer 30 within the effective resonance region AA is not limited in the present disclosure.

In an embodiment of the present disclosure, in the first direction Z, the upper surface of the second gap K2 may be higher than the upper surface of the part of the piezoelectric layer 30 within the effective resonance region AA, i.e., the second electrode connection part 42 may protrude in a direction away from the substrate 10 and then extend downwards to the surface of the piezoelectric layer 30, so that the second gap K2 is formed between the second electrode connection part 42 and the piezoelectric layer 30.

In another embodiment of the present disclosure, in the first direction Z, the upper surface of the second gap K2 may align with the upper surface of the part of the piezoelectric layer 30 within the effective resonance region AA. As the piezoelectric layer 30 gradually extends downwards to the surface of the substrate 10, the second electrode connection part 42 may directly extend horizontally, so that the second gap K2 is formed between the second electrode connection part 42 and the piezoelectric layer 30.

In still another embodiment of the present disclosure, in the first direction Z, the upper surface of the second gap K2 is lower than an upper surface of a part of the piezoelectric layer 30 within the effective resonance region AA, i.e., the second electrode connection part 42 recesses towards the substrate 10 and extends to the surface of the piezoelectric layer 30, so that the second gap K2 is formed between the second electrode connection part 42 and the piezoelectric layer 30.

Nevertheless, irrespective of the method used to form the second gap K2 between the second electrode connection part 42 and the piezoelectric layer 30, it is required to limit the height of the second gap K2 in the first direction Z to ensure the mechanical stability of the bulk acoustic resonator.

In an embodiment of the present disclosure, in the first direction Z, a distance from an upper end to a lower end of a cross-section of the second gap K2 ranges from 10nm to 200nm, including endpoint values. In the embodiment, the height of the second gap K2 in the first direction Z is not extremely large, making the second gap K2 more stable, so that the bulk acoustic resonator has better mechanical stability.

Furthermore, in an embodiment of the present disclosure, in the first direction Z, the distance from the upper end to the lower end of the cross-section of the second gap K2 ranges from 30nm to 50nm, including endpoint values, which makes the second gap K2 more stable, so that the bulk acoustic resonator has better mechanical stability.

The distance from the upper end to the lower end of the cross-section of the second gap K2 in the first direction Z is not limited in the present disclosure, as long as the distance from the upper end to the lower end of the cross-section of the second gap K2 in the first direction Z can make the second gap K2 more stable.

In the embodiment of the present disclosure, the projection of the second gap K2 in the first direction Z interlaces and overlaps with the projection of the first gap K1 in the first direction Z, which indicates that the projection of the second gap K2 in the first direction Z partially overlaps with the projection of the first gap K1 in the first direction Z, i.e., there is a part of the projection of the second gap K2 in the first direction Z that does not overlap with the projection of the first gap K1 in the first direction Z, and there is a part of the projection of the first gap K1 in the first direction Z that does not overlap with the projection of the second gap K2 in the first direction Z. In other words, as shown in Figures 2 to 12 that illustrate cross-sectional views of a bulk acoustic resonator, in the first direction Z, the initial end of the second gap K2 is located between the initial end and the terminal end of the first gap K1.

It should be noted that an size of the overlapping region between the projection of the second gap K2 in the first direction Z and the projection of the first gap K1 in the first direction Z is not limited in the present disclosure, as long as the projection of the first gap K1 in the first direction Z interlaces and overlaps with the projection of the second gap K2 in the first direction Z, a double reflection structure of a double-layer gap may be formed, so as to suppress the resonance of transverse waves, which reduces the loss in the acoustic energy.

In an embodiment of the present disclosure, a width of the overlapping region between the projection of the second gap K2 in the first direction Z and the projection of the first gap K1 in the first direction Z is greater than or equal to half of a width of the first gap K1. In such case, the size of the overlapping region between the projection of the first gap K1 in the first direction Z and the projection of the second gap K2 in the first direction Z is relatively large, to enable a better effect of reflecting the transverse waves through the double-layer gap structure.

In the embodiment of the present disclosure, the first gap K1 and the second gap K2 may be filled with air, or a dielectric material, e.g., a dielectric material with a low dielectric constant, such as SiO₂ (silicon dioxide), PSG (phosphosilicate glass), PI (polyimide), SiOC (silicon oxycarbide), aerosols or the like.

From the above analysis, in the bulk acoustic resonator according to the embodiment of the present disclosure, the initial end of the first gap K1 coincides with the terminal end of the effective resonance region AA, and the terminal end of the first gap K1 is located at an outer side of the terminal end of the effective resonance region AA. In other words, the first gap K1 separates the first electrode 20 from the piezoelectric layer 30 from the terminal end of the effective resonance region AA in a direction away from the effective resonance region AA. The initial end of the second gap K2 is located between the initial end and the terminal end of the first gap K1, and the terminal end of the second gap K2 is located at the outer side of the terminal end of the first electrode 20. That is, the second gap K2 separates the piezoelectric layer 30 from the second electrode connection part 42 from the inside of the first gap K1 to the outer side of the terminal end of the first electrode 20 in the direction away from the effective resonance region AA.

In other words, from the terminal end of the effective resonance region AA to the outer side of the terminal end of the first electrode 20 in the direction away from the effective resonance region AA, first, the first electrode 20 is separated from the piezoelectric layer 30 by the first gap K1 and, then, the piezoelectric layer 30 is separated from the second electrode connection part 42 by the second gap K2. In this way, such double-layer gap structure, including the first gap K1 and the second gap K2, arranged at the boundary of the effective resonance region AA, ensures complete isolation among the first electrode 20, the piezoelectric layer 30 and the second electrode 40 at the boundary of the effective resonance region AA. As a result, there is no overlapping region among the piezoelectric layer 30, the first electrode 20 and the second electrode connection part 42 located outside the effective resonance region AA, which can eliminate the parasitic oscillation in the non-effective resonance region.

In addition, the first gap K1 between the first electrode 20 and the piezoelectric layer 30 forms a morphological change among the first electrode 20, the first gap K1, and the piezoelectric layer 30. The second gap K2 between the piezoelectric layer 30 and the second electrode connection part 42 forms a morphological change among the piezoelectric layer 30, the second gap K2, and the second electrode connection part 42. In addition, acoustic impedance changes occur in both the first gap K1 and the second gap K2, which enables the first gap K1 and the second gap K2 to reflect the transverse waves, minimizing the leakage of the transverse waves, to improve the Q factor of the device. Furthermore, with the double-layer gap structure, including the first gap K1 and the second gap K2, arranged at the boundary of the effective resonance region AA, it can form a double reflection structure, which can enhance the effect of reflecting the transverse waves. In this way, it enables total reflection at the boundary of the effective resonance region AA, reducing the loss in the acoustic energy. In addition, it significantly confines the acoustic wave energy to resonate in a longitudinal mode. Particularly, when the two gaps are filled with air, the acoustic waves at an air interface exhibit high reflection efficiency, effectively reducing acoustic energy loss.

Further, in the bulk acoustic resonator according to the embodiment of the present disclosure, the first electrode 20, the piezoelectric layer 30, and the second electrode 40 are separated from each other by the gaps at the boundary of the effective resonance region AA, allowing them in a relative free state each, this eliminates the stress transfer phenomenon resulting from direct contact between the electrode layers and the piezoelectric layer at the boundary of the effective resonance region. Consequently, thin film stress of the electrode layers and the piezoelectric layer is effectively reduced, leading to decreased stress accumulation at the boundary of the effective resonance region AA. Notably, the air-filled gap demonstrates a more pronounced effect in reducing stress transfer compared to a gap filled with dielectric material.

In a case that the gap is on a micrometer scale, generally, ranging from 1µm to 10µm, both the piezoelectric layer and the electrode layers have large local moments, which can offer a robust support for the structure of the bulk acoustic resonator. In addition, with the first gap K1 interlacing and overlapping with second gap K2 in the first direction Z, it enables the piezoelectric layer and the electrode layers have reasonable and complementary structures, so that the electrode layers and the piezoelectric layer are in a stress balance state due to the mutual support at the two gaps, thereby forming a strong and stable structure.

Especially, in the direction perpendicular to the plane where the substrate 10 is located (i.e., the first direction Z), the upper surface of the first gap K1 is not higher than the upper surface of the part of the first electrode 20 within the effective resonance region, so that the piezoelectric layer 30 gradually transitions to the surface of the substrate 10, reducing the stress of the piezoelectric layer 30, thereby further enhancing the reliability of the structure of the bulk acoustic resonator.

In addition, the conventional bulk acoustic resonator tends to deform and exhibit poor mechanical stability when exposed to external forces or temperature fluctuations. Currently, a single gap is arranged at the boundary of the effective resonance region to reflect transverse waves. However, this approach not only yields limited effectiveness in reflecting transverse waves but also poses challenges, i.e., the single air gap is prone to fractures or collapses due to its large size, ultimately compromising the overall structural stability of the bulk acoustic resonator. Hence, in the bulk acoustic resonator according to the embodiments of the present disclosure, by arranging the projection of the first gap K1 in the first direction Z interlaces and overlaps with the projection of the second gap K2 in the first direction Z, it reduces the size of the single gap, preventing it from being fractured or collapsed due to excessively long or high. Additionally, the double-layer gap structure enhances the length of the gap in the horizontal direction, enabling the bulk acoustic resonator to withstand structural deformations and ensuring excellent mechanical stability.

Technical solutions of embodiments of the present disclosure are described below clearly and completely in conjunction with the drawings of the embodiments of the present disclosure. Apparently, the embodiments described below are only some embodiments of the present disclosure, rather than all the embodiments. All other embodiments obtained by those skilled in the art based on the embodiments in the present disclosure without any creative effort fall within the protection scope of the present disclosure.

Details are set forth in the following description to facilitate a thorough understanding of the present disclosure. Nevertheless, the present disclosure may be implemented in other manners different from those described herein. Those skilled in the art may make similar modifications without departing from the concept of the present disclosure. Therefore, the present disclosure is not limited by the following embodiments disclosed.

In addition, the present disclosure is described in detail in conjunction with schematic diagrams. To facilitate description in describing embodiments of the present disclosure in detail, a cross-sectional view showing a structure of a device is partially enlarged, not on a general scale. The schematic diagrams are merely exemplary, which are not intended to limit the protection scope of present disclosure. In addition, the three-dimensional spatial dimensions of length, width and depth should be included in practical manufacture.

Figure 2 is a schematic cross-sectional view of a bulk acoustic resonator according to an embodiment of the present disclosure. As shown in Figure 2, in this embodiment, the first electrode 20 protrudes upwards from the surface of the substrate 10, and the acoustic reflection component 50 is formed between the protrusion of the first electrode 20 and the surface of the substrate 10. The protrusion of the first electrode 20 includes a first sloping region Z1 with an inclined angle relative to the surface of the substrate 10.

The initial end of the first gap K1 coincides with an initial end of the first sloping region Z1, and the terminal end of the first gap K1 extends beyond a terminal end of the first sloping region Z1.

In the embodiment, the acoustic reflection component 50 is arranged on the surface of the substrate 10, and edges of the acoustic reflection component 50 are gradually thinned to termination. When the first electrode 20 covers the acoustic reflection component 50, a first sloping region Z1 with an inclined angle relative to the surface of the substrate 10 is formed, to enable the first gap K1 to be formed between the first sloping region Z1 and the piezoelectric layer 30. In this way, in the first direction Z, the initial end of the first gap K1 coincides with the initial end of the first sloping region Z1, coincides with the terminal end of the effective resonance region AA, and also coincides with a turning point of an edge of the acoustic reflection component 50. The terminal end of the first gap K1 is located beyond the terminal end of the first sloping region Z 1.

It should be noted that the initial end of the first sloping region Z1 is an end of the first sloping region Z1 close to the effective resonance region AA, and the terminal end of the first sloping region Z1 is an end of the first sloping region Z1 away from the effective resonance region AA.

In the embodiment, in the first direction Z, the initial end of the second gap K2 is located between the initial end and the terminal end of the first gap K1, and the terminal end of the second gap K2 extends beyond the terminal end of the first electrode 20, so that the first gap K1 overlaps with the second gap K2 in the first direction Z to form the double-layer gap structure. In this way, the first electrode 20, the piezoelectric layer 30, and second electrode 40 are completely separated from each other at the boundary of the effective resonance region AA, which can eliminate the parasitic oscillation in the non-effective resonance region when the second electrode 40 is connected outwards.

In addition, since the morphological change and the acoustic impedance change occur in material layers around the first gap K1 and second gap K2, the transverse waves are reflected, which reduces the leakage of the transverse waves and improves the Q factor of the bulk acoustic resonator. Furthermore, the double-layer gap structure can enhance the effect of reflecting the transverse waves, which enables total reflection at the boundary of the effective resonance region, reducing the loss in the acoustic energy. In addition, it significantly confines the acoustic wave energy to resonate in a longitudinal mode.

It should be noted that the acoustic reflection component 50 is arranged on the surface of the substrate 10, and the edges of the acoustic reflection component 50 may be gradually thinned to termination, i.e., the edge surfaces of the acoustic reflection component 50 are arc-shaped. In such case, the morphological change in the first electrode 20 in the first sloping region Z1 is relatively small, and subsequent growth of the piezoelectric layer 30 thereon also exhibits minor morphological change, which helps minimize defects in the various layers grown on the acoustic reflection component 50, thereby improving the growth quality of these layers and reducing parasitic oscillations. The shape of the edge surface of the acoustic reflection component 50 is not limited in the present disclosure. The edges of the acoustic reflection component 50 may be terminated, vertically, in an inclined manner, a stepped manner or other manner.

When the edges of the acoustic reflection component 50 are relatively steep, the morphological change in the first electrode 20 in the first sloping region Z1 is relatively significant, similarly, the morphological change in a part of the piezoelectric layer 30 corresponding to the first sloping region Z1 is also relatively substantial, which impacts the piezoelectric performance of the piezoelectric layer 30. In view of this, in this embodiment, the first gap K1 is formed between the first sloping region Z1 and the piezoelectric layer 30, and in the first direction, the upper surface of the first gap K1 is not higher than the upper surface of the part of the piezoelectric layer 30 within the effective resonance region, so that a there is a small morphological change in the piezoelectric layer 30, transitioning from the effective resonance region AAto the surface of the substrate 10 smoothly, which reduces the stress of the piezoelectric layer 30 while enhancing the reliability of the structure of the bulk acoustic resonator. Further, in the embodiment, the upper surface of the first gap K1 is arc-shaped, and the piezoelectric layer 30 grown on the upper surface of the first gap K1 is also arc-shaped with a gradual transition. In this way, it minimizes morphological changes, reduces growth defects, ensures high growth quality, and enhances piezoelectric performance.

In the embodiment, the electrode layers and piezoelectric layer are separated from each other by the gaps at the boundary of the effective resonance region AA. In a case that the gap is on a micrometer scale, for example, ranging from 1µm to 10µm, both the piezoelectric material and the metal electrode material have extremely large local moments, which can form robust support for the structure of the bulk acoustic resonator. Therefore, a film thickness and a size of the gap can be reasonably determined to effectively reduce the stress during film deposition, so that all film layer are separated from each other by gaps at the boundary of the effective resonance region AA, allowing each of them in a relative free state, which substantially reduces the stress accumulation of the bulk acoustic resonator at the boundary of the effective resonance region AA. In addition, the electrode layers and piezoelectric layer support each other through the double-layer gap structure to be in a stress balance state, enhancing the stability of the structure of the device. In addition, the double-layer gap structure may better withstand structural deformation and have better mechanical stability when exposed to external forces or temperature fluctuations.

In the embodiment, the acoustic reflection component 50 may be a cavity or a Bragg reflector. In a case that the acoustic reflection component 50 is the Bragg reflector, the acoustic reflection component 50 may be directly formed on the surface of the substrate 10 or embedded into the substrate 10. In a case that the acoustic reflection component 50 is the cavity, a sacrificial layer is first formed at a position where the acoustic reflection component 50 is to be formed on the surface of the substrate 10, then the first electrode 20, the piezoelectric layer 30, and the second electrode 40 are sequentially formed on the sacrificial layer, and finally the sacrificial layer is removed to obtain the cavity structure.

In the embodiment, the first gap K1 and the second gap K2 may be filled with air, or a dielectric material, such as a dielectric material with a low dielectric constant, such as SiO₂ (silicon dioxide), PSG (phosphosilicate glass), PI (polyimide), SiOC (silicon oxycarbide), aerosols or the like, which is applied to any one of the embodiment of the present disclosure. In addition, when the two gaps are filled with air, the acoustic waves at the air interface have a high reflection efficiency, so that the loss of the acoustic energy can be effectively reduced, and the air-filled gap demonstrates a more pronounced effect in reducing stress transfer compared to a gap filled with dielectric material.

In a case that the first gap K1 and the second gap K2 are filled with air, a sacrificial layer is directly deposited on an upper surface of the first electrode 20, then the piezoelectric layer 30 and the second electrode 40 are deposited on the sacrificial layer, and the sacrificial layer is removed, to form the first gap K1. Similarly, the second gap K2 is also formed by depositing a sacrificial layer and ultimately removing the sacrificial layer. Through such process, a thickness of the formed piezoelectric layer 30 is constant in the horizontal direction, that is, in the embodiment, the thickness at each positions of the piezoelectric layer 30 is equal in the first direction. In such process, no processing operation (such as etching) is performed on the first electrode 20 and the piezoelectric layer 30, to ensure the quality and the performance of the electrode layers and the piezoelectric layer 30. In this way, the c-axis orientation and the mechanical stability of the piezoelectric layer 30 can be improved, the piezoelectric layer is of better piezoelectric consistency and uniform stress distribution. It should be noted that the sacrificial layer for forming the cavity and gaps may be made of a dielectric material, such as Si, SiO₂, PSG, Si₃N₄, and the like.

In a case that the first gap K1 and the second gap K2 are filled with the dielectric material, the dielectric material may be directly deposited at positions where the first gap K1 and the second gap K2 are to be formed. Alternatively, sacrificial layers may be deposited at the positions where the first gap K1 and the second gap K2 are to be formed, the sacrificial layer may be removed, and then the first gap K1 and the second gap K2 are filled with the dielectric material, which depends on the actual situation.

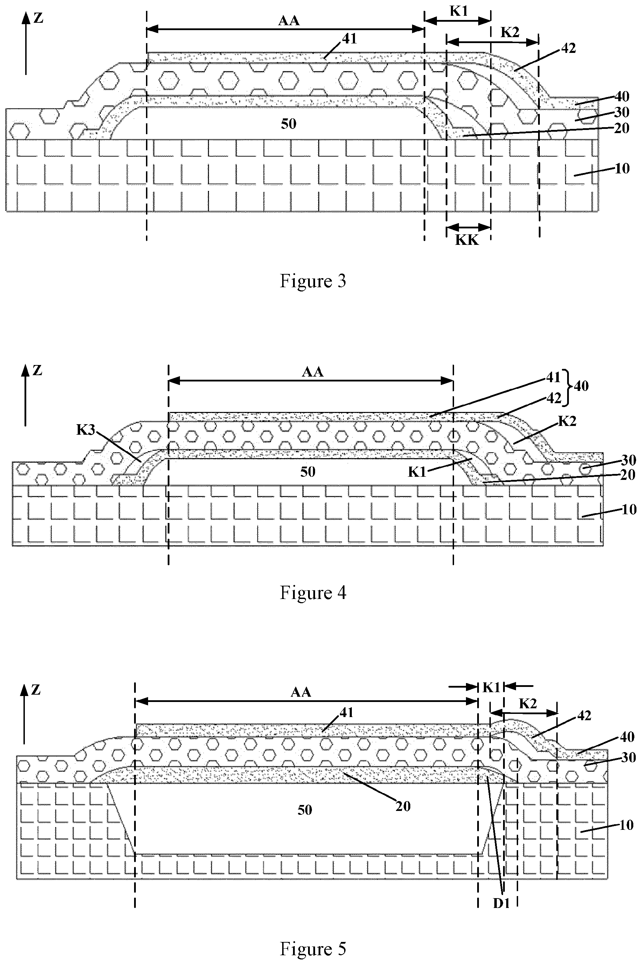

Figure 3 is a schematic cross-sectional view of a bulk acoustic resonator according to another embodiment of the present disclosure. As shown in Figures 2 to 3, in the embodiments, the terminal end of the first gap K1 may be located at the inner side of the terminal end of the first electrode 20 (as shown in Figure 2) or may extend beyond the terminal end of the first electrode 20 (as shown in Figure 3).

Further, as shown in Figure 3, a width of the overlapping region KK between the projection of the first gap K1 in the first direction Z and the projection of the second gap K2 in the first direction Z is greater than or equal to half of a width of the first gap K1. In such case, the overlapping region KK between the projection of the first gap K1 in the first direction Z and the projection of the second gap K2 in the first direction Z is relatively large, resulting in a better effect of reflecting the transverse waves through the double-layer gap structure.

In the embodiment, as shown in Figures 2 and 3, in the first direction Z, the upper surface of the second gap K2 is not higher than the upper surface of the part of the piezoelectric layer 30 within the effective resonance region, and the second electrode connection part 42 recesses towards the first electrode 20 and extends to the surface of the piezoelectric layer 30, so that the second gap K2 is formed between the second electrode connection part 42 and the piezoelectric layer 30.

Figure 4 is a schematic cross-sectional view of a bulk acoustic resonator according to an embodiment of the present disclosure. As shown in Figure 4, in the embodiment, a third gap K3 is further provided between the first electrode 20 and the piezoelectric layer 30. The third gap(s) K3 is (are) located on one or more sides of the effective resonance region AA away from the first gap K1, and a terminal end (i.e., a non-connection end of the second electrode 40) of the second electrode 40 away from the second electrode connection part 42 does not extend beyond a terminal end of the third gap K3.

In the first direction Z, the upper surface of the third gap K3 is not higher than the upper surface of the part of the first electrode 20 within the effective resonance region.

It should be noted that the first electrode 20 and the second electrode 40 each may have multiple sides, for example, each may be in a pentagon shape. Where, the second electrode connection part 42 is connected to a side of the second electrode 40. Accordingly, the first gap K1 is also located on a side of the first electrode 20 corresponding to the second electrode connection part 42. In the embodiment, the third gap(s) K3 is (are) arranged on one or more sides of the first electrode 20 that are not provided with the first gap K1, so that the third gap(s) K3 is (are) arranged to surround one or more sides of the effective resonance region AA, and the third gap K3 is located between the first electrode 20 and the piezoelectric layer 30. Similar to the first gap K1, the third gap K3 also forms a morphological change in the first electrode 20, the third gap K3, and the piezoelectric layer 30, resulting in the acoustic impedance change, which functions as reflecting the transverse waves, reducing the leakage of the transverse waves, and improving the Q factor of the device.

In addition, the first gap K1 and the third gap K3 are located on different sides of the first electrode 20, causing the transverse waves to be reflected between the first gap K1 and the third gap K3 back and forth, which restrains the transverse waves in the effective resonance region AA. In this way, it further reduces the leakage of the transverse waves and improves the Q factor of the device.

In this embodiment, the non-connection end of the second electrode 40 does not extend beyond the terminal end of the third gap K3, so that there is no overlapping region between the non-connection end of the second electrode 40, the piezoelectric layer 30 and the first electrode 20, thereby avoiding the parasitic oscillation in the non-effective resonance region.

It should further be noted that since the third gap K3 is located between the first electrode 20 and the piezoelectric layer 30, the upper surface of the third gap K3 is an interface between the third gap K3 and the piezoelectric layer 30 in the first direction Z.

In the embodiment, in the first direction Z, the upper surface of the third gap K3 is not higher than the upper surface of the part of the first electrode 20 within the effective resonance region AA, so that the piezoelectric layer 30 gradually transitions to the surface of the substrate 10 with a small morphological change, reducing the stress of the piezoelectric layer 30 while further enhancing the reliability of the structure of the bulk acoustic resonator. Further, in the embodiment, the upper surface of the third gap K3 is arc-shaped, and the piezoelectric layer 30 grown on the upper surface of the third gap K3 is also arc-shaped and steadily transitions. In this way, it minimizes morphological change in the piezoelectric layer 30, reduces growth defects, ensures high growth quality, and enhances piezoelectric performance.

In an embodiment, the third gap K3 is formed by the first gap K1 surrounding the effective resonance region AA, and the third gap K3 is in communication with the first gap K1, i.e., the first gap K1 between the first electrode 20 and the piezoelectric layer 30 may be arranged to be an air ring or a dielectric ring surrounding the side of the first electrode 20, to separate the first electrode 20 from the piezoelectric layer 30 at the boundary of the effective resonance region AA. The first gap K1 arranged in a ring shape may effectively reflect the transverse waves, suppress the leakage of the transverse waves, reduce the loss in the acoustic energy, and improve the overall performance of the bulk acoustic resonator, which is not limited in the present disclosure. In an embodiment, the third gap K3 may be not in communication with the first gap K1, which depends on the actual situation.

It should be noted that the third gap K3 arranged between the first electrode 20 and the piezoelectric layer 30 to reflect the transverse wave may be applied to any one of the embodiments of the present disclosure.

Figure 5 is a schematic cross-sectional view of a bulk acoustic resonator according to an embodiment of the present disclosure. As shown in Figure 5, in the embodiment, the first electrode 20 includes a first thinning region D 1. A thickness of the first thinning region D1 is less than a thickness of the part of the first electrode 20 within the effective resonance region. The first gap K1 is formed between at least a part of the first thinning region D1 and the piezoelectric layer 30, and an initial end of the first thinning region D1 coincides with the initial end of the first gap K1.

In the embodiment, the acoustic reflection component 50 may be a cavity or Bragg reflector that is embedded in the substrate 10. Alternatively, the acoustic reflection component 50 may be a cavity or Bragg reflector that is located on the surface of the substrate 10. In both cases, the first thinning region D1 may be formed in the first electrode 20, so that the first gap K1 is formed between at least the part of the first thinning region D1 and the piezoelectric layer 30. Hereinafter, the cavity-type bulk acoustic resonator is described with an example where the acoustic reflection component 50 is embedded in the substrate 10.

In the embodiment, the initial end of the first thinning region D1 is an end of the first thinning region D 1 closed to the effective resonance region AA, and a terminal end of the first thinning region D 1 is an end of the first thinning region D 1 away from the effective resonance region AA.

In the embodiment, in the first direction Z, the upper surface of the first thinning region D1 may be arc-shaped, inclined, stepped, or groove-shaped.

In an embodiment, as shown in Figure 5, in the first direction, the upper surface of the first thinning region D1 is arc-shaped, and the initial end of the first gap K1 coincides with the initial end of the arc-shaped first thinning region D1 of the first electrode 20. In the first direction Z, the upper surface of the first thinning region D1 is arc-shaped, and the upper surface of the first gap K1 is not higher than the upper surface of the part of the piezoelectric layer 30 within the effective resonance region, which facilitates the morphological of the piezoelectric layer 30 to steadily transition during the subsequent growth, thereby reducing the growth defect of the piezoelectric layer 30 at the boundary of the effective resonance region AA and improving the growth quality of the piezoelectric layer 30.

In the embodiment, as shown in Figure 5, the terminal end of the first thinning region D1 coincides with the terminal end of the first electrode 20, i.e., the first electrode 20 is gradually thinned to termination through the arc-shaped first thinning region D 1. In such case, the initial end of the first gap K1 coincides with the initial end of the first thinning region D1. The terminal end of the first gap K1 may be located at the inner side of the terminal end of the first electrode 20 (as shown in Figure 5), may coincide with the terminal end of the first electrode 20, or may be located at the outer side of the terminal end of the first electrode 20, which depends on the actual situation.

In the embodiment, in the first direction Z, the upper surface of the second gap K2 may be higher than the upper surface of the part of the piezoelectric layer 30 within the effective resonance region. As shown in Figure 5, the second electrode connection part 42 protrudes in a direction away from the first electrode 20, and then extends downwards to the surface of the piezoelectric layer 30, so that the second gap K2 is formed between the second electrode connection part 42 and the piezoelectric layer 30. In such case, the second gap K2 protrudes upwards and has a great morphological change, which can further reflect the transverse waves, reduce the leakage of the transverse waves into the metal medium on a side of the second electrode 40 is connected outwards, thereby improving the Q factor of the bulk acoustic resonator.

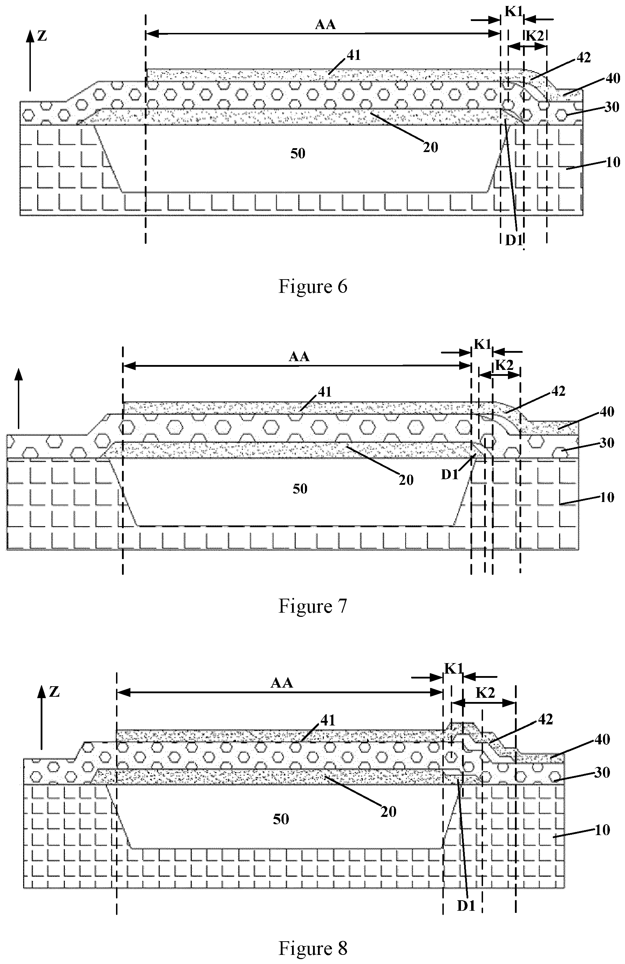

Figures 6 and 7 schematic cross-sectional views of a bulk acoustic resonator according to an embodiment of the present disclosure. In this embodiment, in the first direction Z, the upper surface of the first thinning region D1 is inclined, and the initial end of the first gap K1 coincides with the initial end of the inclined-shaped first thinning region D1 of the first electrode 20.

In the embodiment, as shown in Figures 6 and 7, the terminal end of the first thinning region D1 coincides with the terminal end of the first electrode 20, i.e., the first electrode 20 is gradually thinned to termination through the inclined-shaped first thinning region D1. In such case, the terminal end of the first gap K1 may be located at the inner side of the terminal end of the first thinning region D 1, may coincide with the terminal end of the first electrode 20 (as shown in Figure 6), or may be located at the outer side of the terminal end of the first electrode 20 (as shown in Figure 7), which depends on the actual situation.

In the embodiment, as shown in Figures 6 and 7, since the upper surface of the first thinning region D1 is inclined-shaped in the first direction Z, and the upper surface of the first gap K1 is not higher than the upper surface of the part of the piezoelectric layer 30 within the effective resonance region AA, the morphological of the piezoelectric layer 30 may steadily transition during growth, thereby reducing the growth defect of the piezoelectric layer 30 at the boundary of the effective resonance region AA and improving the growth quality of the piezoelectric layer 30.

In the embodiment, as shown in Figures 6 and 7, in the first direction Z, the upper surface of the second gap K2 is not higher than the upper surface of the part of the piezoelectric layer 30 within the effective resonance region AA, and the second electrode connection part 42 recesses towards the first electrode 20 and extends to the surface of the piezoelectric layer 30, so that the second gap K2 is formed between the second electrode connection part 42 and the piezoelectric layer 30.

Figure 8 is a schematic cross-sectional view of a bulk acoustic resonator according to an embodiment of the present disclosure. As shown in Figure 8, in the first direction Z, the upper surface of the first thinning region D1 is stepped, and the initial end of the first gap K1 coincides with an initial end of the stepped first thinning region D1 of the first electrode 20.

In the embodiment, as shown in Figure 8, the terminal end of the first thinning region D1 coincides with the terminal end of the first electrode 20. In an example, the part of the terminal end of the first electrode 20 is etched to form the stepped first thinning region D1. Subsequently, a sacrificial layer is deposited on the first thinning region D1. The piezoelectric layer 30 and the second electrode 40 are, then, grown. Eventually, the first gap K1 is obtained by removing the sacrificial layer. Since the initial end of the first gap K1 coincides with the initial end of the step and the initial end of the first gap K1 coincides with the terminal end of the effective resonance region AA, when the terminal end of the first electrode 20 is etched, the initial end of the first gap K1, i.e., the terminal end of the effective resonance region AA, may be determined by selecting an etching position. In this way, a region of the piezoelectric layer 30, above the terminal end of the first electrode 20, with a large growth defect is excluded from the effective resonance region AA, which can ensure better growth quality of the part of the piezoelectric layer 30 within the effective resonance region AA, to improve the Q factor of the device.

In the embodiment, as shown in Figure 8, in the first direction, the upper surface of the first gap K1 may align with the upper surface of the part of the first electrode 20 within the effective resonance region AA. In this case, after the end of the first electrode 20 is etched to form the stepped first thinning region D1, the sacrificial layer is deposited on the first thinning region D1, the upper surface of the deposited sacrificial layer aligns with the upper surface of the part of the first electrode 20 within the effective resonance region AA, so that the upper surface of the first electrode 20 may align with the part of the upper surface of the first electrode 20 within the effective resonance region AA after the sacrificial layer is removed.

In the embodiment, as shown in Figure 8, the terminal end of the first gap K1 does not extend beyond a step surface in the stepped first thinning region D1. The quantity of steps in the stepped first thinning region D1 and which step surface the terminal end of the first gap K1 is located on are not limited in the present disclosure, which depend on the actual situation. It can be understood that after the stepped first thinning region D1 is formed at the terminal end of the first electrode 20 and the sacrificial layer corresponding to the first gap K1 is deposited on the first thinning region D1, the surface of the first thinning region D1 and a surface of the sacrificial layer are also changed in a stepped shape (i.e., a stepped change). Therefore, when the piezoelectric layer 30 is grown, the piezoelectric layer 30 changes along the surface of the first thinning region D1 and the surface of the sacrificial layer, i.e., a part of the piezoelectric layer 30 corresponding to the terminal end of the first electrode 20 is also stepped, thereby reducing a sudden morphological change of the piezoelectric layer 30 and reducing the stress change of the piezoelectric layer 30.

In the embodiment, in the first direction Z, the upper surface of the second gap K2 may be higher than the upper surface of the part of the piezoelectric layer 30 within the effective resonance region AA. As shown in Figure 8, the second electrode connection part 42 protrudes in the direction away from the first electrode 20 and then extends downwards to the surface of the piezoelectric layer 30, so that the second gap K2 is formed between the second electrode connection part 42 and the piezoelectric layer 30. In the embodiment, the second electrode connection part 42 protrudes upwards to form a change in a stepped shape, to make the upper surface of the second gap K2 be stepped, so that the first gap K1 and the second gap K2 are formed on a lower side and an upper side of the piezoelectric layer 30 corresponding to the terminal end of the first electrode 20 respectively, to separate the first electrode 20 from the piezoelectric layer 30, and separate the piezoelectric layer 30 from the second electrode connection part 42, respectively, forming a double-layer gap structure.

In an embodiment, as shown in Figure 8, the terminal end of the first gap K1 is located within the step surface in the first thinning region D1 to reduce the morphological change of the piezoelectric layer 30.

In an embodiment, as shown in Figure 8, a depth of the step in the first thinning region D1 does not exceed 50% of a thickness of the first electrode 20.

In the bulk acoustic resonator shown in Figure 8, the acoustic reflection component 50 is a cavity, and the terminal end of the first electrode 20 extends beyond the terminal end of the acoustic reflection component 50. In such case, the first electrode 20 may be supported by the substrate 10, ensuring the mechanical stability of the bulk acoustic resonator, and ensuring the process stability when the first electrode 20 and the piezoelectric layer 30 are deposited, which is not limited in the present disclosure. The terminal end of the first electrode 20 may further be located at the inner side of the terminal end of the acoustic reflection component 50.

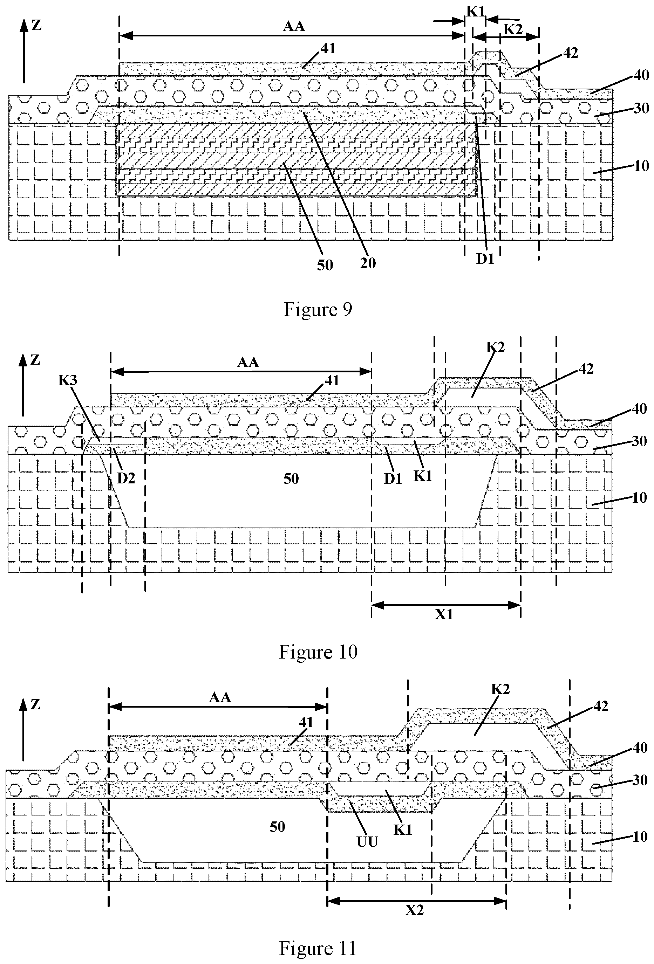

Figure 9 is a schematic cross-sectional view of a bulk acoustic resonator according to another embodiment of the present disclosure. As shown in Figure 9, in this embodiment, the acoustic reflection component 50 may also be a Bragg reflector. The Bragg reflector is formed by alternately stacking low acoustic impedance layers and high acoustic impedance layers with different acoustic impedances.

It should be noted that in various embodiments of the present disclosure, the position of the cavity configured as the acoustic reflection component 50 may be replaced with the Bragg reflector formed by alternately stacking low acoustic impedance layers and high acoustic impedance layers with different acoustic impedances. The Bragg reflector may be embedded in the substrate 10 or located on the surface of the substrate 10.

Figure 10 is a schematic cross-sectional view of a bulk acoustic resonator according to an embodiment of the present disclosure. As shown in Figure 10, in the embodiment, the terminal end of the first thinning region D1 is located at the inner side of the terminal end of the first electrode 20. In this case, the first gap K1 does not correspond to the terminal end of the first electrode 20, but located away from the terminal end of the first electrode 20 and is more close to a center region of the first electrode 20.

In the embodiment, as shown in Figure 10, in the first direction Z, the upper surface of the first thinning region D1 is groove-shaped, i.e., a groove is formed on the first electrode 20 by etching, and a part of the first electrode 20 corresponding to the groove is the first thinning region D 1.

In the embodiment, in the first direction Z, the upper surface of the first gap K1 aligns with the upper surface of the part of the first electrode 20 within the effective resonance region AA. After the first electrode 20 is etched to form the groove, the groove is filled up with a sacrificial layer. Subsequently, the piezoelectric layer 30 is grown on the flat surface of the first electrode 20 and the flat surface of the sacrificial layer, so that the piezoelectric layer 30 above the effective resonance region AA and the entire acoustic reflection component 50 is grown horizontally, which has better growth quality. Finally, after the bulk acoustic resonator is manufactured, the sacrificial layer is removed to form the first gap K1.

In the embodiment, the terminal end of the first gap K1 is located at the inner side of the terminal end of the first electrode 20, and the initial end of the first gap K1 coincides with the terminal end of the effective resonance region AA, i.e., the effective resonance region AA is defined by the initial end of the first gap K1. Hence, compared with the foregoing embodiment, the effective resonance region AA of the bulk acoustic resonator in this embodiment may be reduced. In order to ensure the area of the effective resonance region, as shown in Figure 10, a horizontal distance X1 between the initial end (i.e. the initial end of the first gap K1) of the first thinning region D1 and the terminal end of the first electrode 20 should not be too large. In an embodiment, the horizontal distance X1 between the initial end of the first thinning region D1 and the terminal end of the first electrode 20 is no more than 3µm.

Furthermore, in the embodiment, as shown in Figure 10, a third gap K3 is further provided between the first electrode 20 and the piezoelectric layer 30. The third gap(s) K3 is (are) located on one or more sides of the effective resonance region AA away from the first gap K1, and a terminal end (i.e., a non-connection end of the second electrode 40) of the second electrode 40 away from the second electrode connection part 42 does not extend the terminal end of the third gap K3, so that there is no overlapping region between the non-connection end of the second electrode 40, the piezoelectric layer 30 and the first electrode 20, thereby avoiding the parasitic oscillation in the non-effective resonance region.

In the first direction Z, the upper surface of the third gap K3 is not higher than the upper surface of the part of the first electrode 20 within the effective resonance region AA.

It should be noted that the first electrode 20 and the second electrode 40 each may have multiple sides, for example, each may be in a pentagon shape. Where, the second electrode connection part 42 is connected to a side of the second electrode 40. Accordingly, the first gap K1 is also located on a side of the first electrode 20 corresponding to the second electrode connection part 42. In the embodiment, the third gap(s) K3 is (are) arranged on one or more sides of the first electrode 20 that are not provided with the first gap K1, so that the third gap(s) K3 is (are) arranged to surround one or more sides of the effective resonance region AA, and each third gap K3 is located between the first electrode 20 and the piezoelectric layer 30. Similar to the first gap K1, the third gap K3 also forms a morphological change in the first electrode 20, the third gap K3, and the piezoelectric layer 30, resulting in the acoustic impedance change, which functions as reflecting the transverse waves, reducing the leakage of the transverse waves, and improving the Q factor of the device.

In addition, the first gap K1 and the third gap K3 are located on different sides of the first electrode 20, causing the transverse waves to be reflected between the first gap K1 and the third gap K3 back and forth, which restrains the transverse waves in the effective resonance region AA. In this way, it further reduces the leakage of the transverse waves and improves the Q factor of the device.

Based on this, in an embodiment, as shown in Figure 10, the first electrode 20 includes a second thinning region D2, and a thickness of the second thinning region D2 is less than the thickness of the part of the first electrode 20 within the effective resonance region AA, so that the third gap K3 is formed between the second thinning region D2 and the piezoelectric layer 30.

In the embodiment, as shown in Figure 10, one or more sides of the first electrode 20 that are not provided with the first gap K1 are etched to form a groove-shaped second thinning region D2. The groove is subsequently filled with a sacrificial layer, aligning the upper surface of the sacrificial layer with the upper surface of the part of the first electrode 20 within the effective resonance region AA. In this way, it ensures that the piezoelectric layer 30 is grown on a flat surface, promoting better growth quality. In such case, in the first direction Z, the upper surface of the third gap K3 aligns with the upper surface of the part of the first electrode 20 within the effective resonance region AA.

In an embodiment, the third gap K3 is formed by the first gap K1 surrounding the effective resonance region, and the third gap K3 is in communication with the first gap K1. In other words, the first gap K1 between the first electrode 20 and the piezoelectric layer 30 may be arranged to be an air ring or a dielectric ring surrounding the side of the first electrode 20, to separate the first electrode 20 from the piezoelectric layer 30 at the boundary of the effective resonance region AA. The first gap K1 arranged in a ring shape may effectively reflect the transverse waves, suppress the leakage of the transverse waves, reduce the loss in the acoustic energy, and improve the overall performance of the bulk acoustic resonator, which is not limited in the present disclosure. In an embodiment, the third gap K3 may be not in communication with the first gap K1, which depends on the actual situation.

Figure 11 is a schematic cross-sectional view of a bulk acoustic resonator according to an embodiment of the present disclosure. As shown in Figure 11, in the embodiment, the first electrode 20 is not etched to form the first gap K1. Instead, the first electrode 20 recesses towards the acoustic reflection component 50 to form a recess UU, and the first gap K1 is formed between the recess UU and the piezoelectric layer 30.

In the embodiment, the acoustic reflection component 50 is embedded in the substrate 10 and is a cavity.

As an example, after the substrate 10 is etched to form the cavity, the cavity is first filled with a sacrificial layer, the sacrificial layer in the cavity is subsequently etched downwards to form a recess, then the first electrode 20 is grown along a morphological of the sacrificial layer to form the first electrode 20 with the recess UU. Further, the recess UU of the first electrode 20 is filled with a sacrificial layer, grinding the surface of the first electrode 20, to grow the piezoelectric layer 30 on the flat surface of the first electrode 20. Ultimately, the sacrificial layers are removed to form the cavity and the first gap K1 located between the first electrode 20 and the piezoelectric layer 30. When manufacturing the second gap K2, a sacrificial layer is first formed on the piezoelectric layer 30, and finally the sacrificial layer is removed to form the second gap K2 between the piezoelectric layer 30 and the second electrode connection part 42.

In the embodiment, in the first direction Z, the upper surface of the first gap K1 aligns with the upper surface of the part of the first electrode 20 within the effective resonance region AA, which ensures that the piezoelectric layer 30 above the effective resonance region AA and the entire acoustic reflection component 50 is flat, exhibiting superior growth quality.

In the embodiment, the first electrode 20 recesses towards the acoustic reflection component 50 to form the recess UU, and the first gap K1 is formed between the recess UU and the piezoelectric layer 30. In such case, the terminal end of the first gap K1 is located at the inner side of the terminal end of the first electrode 20 and the inner side of the terminal end of the acoustic reflection component 50, and the initial end of the first gap K1 coincides with the terminal end of the effective resonance region AA, i.e., the effective resonance region AA is defined by the initial end of the first gap K1. Hence, the effective resonance region AA of the bulk acoustic resonator in this embodiment may also be reduced. In order to ensure the area of the effective resonance region, a horizontal distance X2 between the initial end of the first gap K1 and the terminal end of the acoustic reflection component 50 is no more than 3µm.

In the embodiment, the first gap K1 is located between the terminal end of the effective resonance region AA and the terminal end of the acoustic reflection component 50. Further, a distance between the non-effective resonance region and the effective resonance region may be increased to prevent the resonance of the non-effective resonance region from interfering with the resonance of the effective resonance region. In addition, the double-layer gap structure can further eliminate or reduce the generation of the parasitic resonance at the boundary of the effective resonance region.

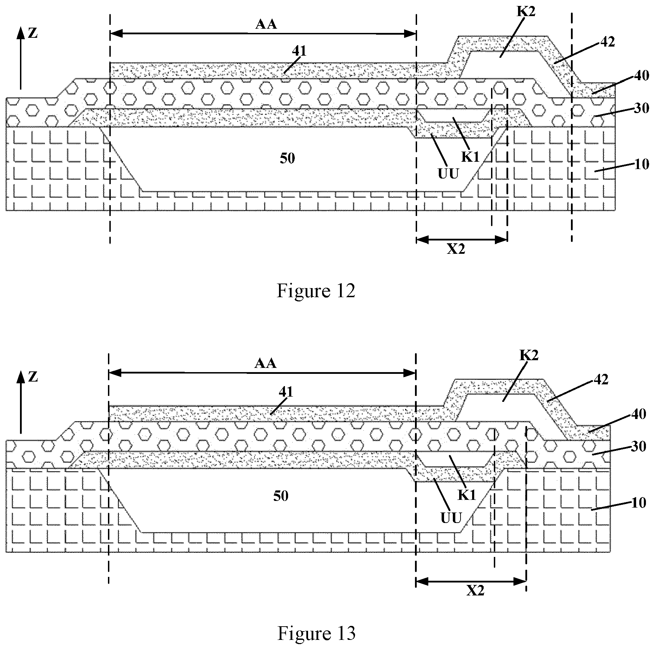

In the bulk acoustic resonator shown in Figure 11, there is a space between a sidewall of the recess UU and a sidewall of the acoustic reflection component 50. Figure 12 is a schematic cross-sectional view of a bulk acoustic resonator according to another embodiment of the present disclosure. Compared with the bulk acoustic resonator shown in Figure 11, a horizontal distance between the sidewall of the recess UU and the sidewall of the acoustic reflection component 50 in the bulk acoustic resonator shown in Figure 12 is further shortened. Figure 13 is a schematic cross-sectional view of a bulk acoustic resonator according to still another embodiment of the present disclosure. As shown in Figure 13, the sidewall of the recess UU may directly be in contact with the sidewall of the acoustic reflection component 50. In such case, the area of the effective resonance region AA is relatively large. Whether the sidewall of the recess UU is directly in contact with the sidewall of the acoustic reflection component 50, and the specific value of the space when it provided, are not limited in the present disclosure, which depend on the actual situation.

It should be noted that in the above embodiments, in the first direction Z, the thickness of the piezoelectric layer 30 may be uniform at all locations, which indicates that the piezoelectric layer 30 is not subjected to any physical damage (such as etching). Therefore, the local stress of the piezoelectric layer 30 is not damaged. Across the entire wafer, the uniform thickness of the piezoelectric layer 30 in the horizontal direction leads to minimal fluctuations in stress distribution, ensuring a more even stress distribution. This, in turn, enhances the yield of the device, improves the effective electromechanical coupling coefficient of the device, and ensures mechanical strength and reliability.

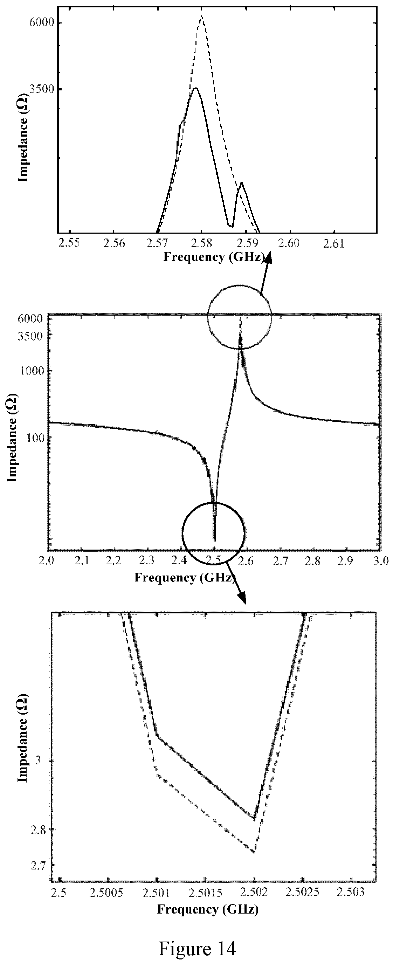

Figure 14 illustrates graphs of impedance-frequency relationships of a bulk acoustic resonator according to an embodiment of the present disclosure compared with a conventional sandwich-structure bulk acoustic resonator. Where, a solid line represents the conventional sandwich-structure bulk acoustic resonator, and a dashed line represents the bulk acoustic resonator according to the embodiment of the present disclosure. From Figure 14, it shows that a parallel impedance Rp of the bulk acoustic resonator according to the embodiment of the present disclosure is increased (from 350052 to 6000Q) compared with the conventional sandwich-structure bulk acoustic resonator, and a series impedance Rs is reduced (from 2.90Ω to 2.74Ω). It can be seen that the bulk acoustic resonator with the double-layer gap structure can significantly reduce the series impedance Rs while increasing the parallel impedance Rp, which indicates that the double-layer gap structure can effectively reduce the parasitic oscillation.

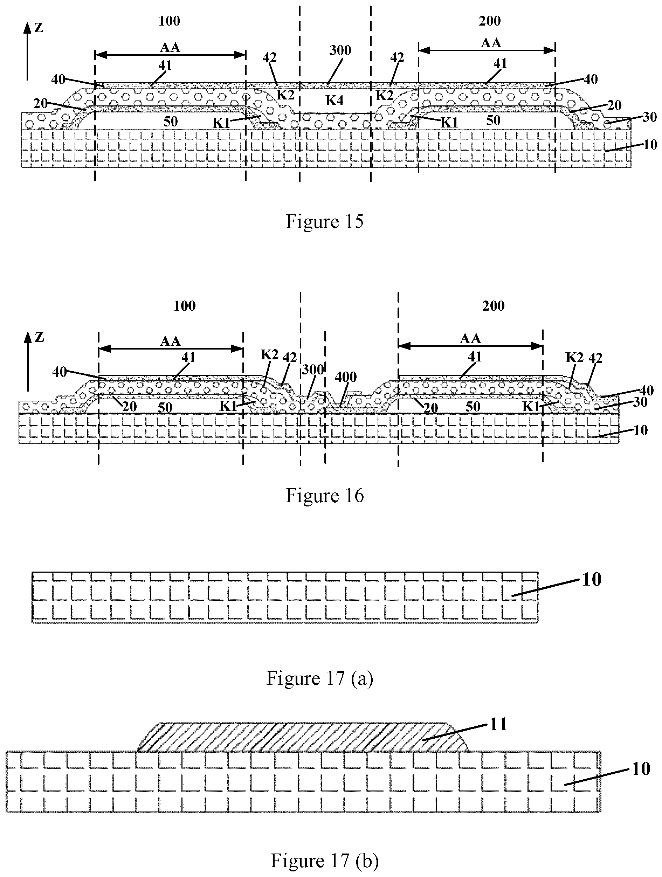

A resonator assembly is further provided according to an embodiment of the present disclosure. As shown in Figures 15 and 16, the resonator assembly at least includes a first resonator 100, an electrical component 200, and a connection structure 300. The first resonator 100 is the bulk acoustic resonator according to any one of the above embodiments. Two ends of the connection structure 300 are connected to a second electrode connection part 42 of the first resonator 100 and the electrical component 200, respectively.

In an embodiment, the electrical component 200 may be a resonator, an inductor, a capacitor, a pad, or the like.

In an embodiment, in a case that the electrical component 200 may be a resonator, the resonator is identical to the first resonator 100. In other words, the electrical component 200 also includes the substrate 10, the first electrode 20, the piezoelectric layer 30, and the second electrode 40 are sequentially stacked on the surface of the substrate 10. The piezoelectric layer 30 extends beyond a terminal end of the first electrode 20. An acoustic reflection component 50 is arranged between the first electrode 20 and the substrate 10. An overlapping part of the acoustic reflection component 50, the first electrode 20, the piezoelectric layer 30, and the second electrode 40 is the effective resonance region AA. A first gap K1 is provided between the first electrode 20 and the piezoelectric layer 30. An initial end of the first gap K1 coincides with a terminal end of the effective resonance region AA. In a first direction Z, an upper surface of the first gap K1 is not higher than an upper surface of a part of the first electrode 20 within the effective resonance region AA. In addition to a part 41 of the second electrode 40 located within the effective resonance region AA, the second electrode 40 further includes a second electrode connection part 42. A second gap K2 is provided between the second electrode connection part 42 and the piezoelectric layer 30. A terminal end of the second gap K2 is located at the outer side of the terminal end of the first electrode 20. A projection of the second gap K2 in the first direction Z overlaps with the projection of the first gap K1 in the first direction Z.

In an embodiment of the present disclosure, as shown in Figure 15, in the first direction Z, an upper surface of the connection structure 300 aligns with the upper surface of the part of the second electrode 40 within the effective resonance region AA of the first resonator 100, and a fourth gap K4 is provided between the connection structure 300 and the piezoelectric layer 30.

In the embodiment, both the second electrode connection part 42 of the first resonator 100 and the connection structure 300 may align with the upper surface of the part of the second electrode 40 within the effective resonance region AA of the first resonator 100, and the piezoelectric layer 30 extends from the effective resonance region AA of the first resonator 100 to the surface of the substrate 10, so that the fourth gap K4 is provided between the connection structure 300 and the piezoelectric layer 30.

For example, as shown in Figure 15, the electrical component 200 is a resonator that is identical to the first resonator 100. The second electrode connection parts 42 of the two resonators are connected through the connection structure 300, and the first electrode 20 is disconnected. In such case, as shown in Figure 15, in the two resonators, a terminal end of the first gap K1 may not extend beyond the terminal end of the first electrode 20, and the upper surface of the second gap K2 aligns with an upper surface of a part of the piezoelectric layer 30 within the effective resonance region AA, that is, the second electrode 40 above the second gap K2 extends horizontally from one resonator to the other resonator and is connected to the second electrode 40 of the other resonator.

It should be noted that, in practical application, the second electrode 40 and the connection structure 300 are simultaneously formed through deposition and are arranged in a same metal layer. However, the connection structure 300 is required to be etched, and the fourth gap K4 is provided between the connection structure 300 and the piezoelectric layer 300, so that the piezoelectric layer below the connection structure is not damaged when the connection structure is etched, ensuring the integrity of the piezoelectric layer on a surface of the entire resonator assembly, avoiding stress changes in a part of the piezoelectric layer close to the effective resonance region, and improving a power tolerance and the performance of anti-electrostatic breakdown of the resonator assembly, to the greatest extent.

In addition, in the embodiment, both the second electrode connection part 42 of the first resonator 100 and the connection structure 300 may align with the upper surface of the part of the second electrode 40 within the effective resonance region of the first resonator 100, which has advantages as follows.
(a). The entire second electrode and the connection structure are horizontally flat without any bend, resulting in a high mechanical stability.
(b). The horizontal second electrode connection part and the connection structure cannot be shortened in length, which provides a transverse stretching effect for the central region of the resonator, thereby preventing the central region of the resonator from being collapsed and deformed.
(c). A passivation layer grown above the horizontal second electrode and the connection structure has high uniformity in the thickness, which facilitates centralized frequency distribution, thereby improving the yield of the device.
(d). The photolithography effect and the etching effect of the horizontal second electrode and the connection structure as well as the alignment effect between the metal layer and the piezoelectric layer are superior, resulting in optimized processing process and low cost.
(e). The horizontal second electrode connection part and the connection structure minimize the connection distance from the first resonator to other electrical components, reducing connection resistance. Consequently, the loss in the acoustic waves is diminished and the quality factor (Q factor) of the device is enhanced.

It should be noted that in a case that the first resonator 100 is connected to the electrical component 200 through the second electrode connection part 42 of the first resonator 100 and the connection structure 300, the second electrode connection part 42 of the first resonator 100 and the connection structure 300 are actually the same metal layer. In a case that a metal layer of the electrical component 200 for connecting is the same as the metal layer of the second electrode connection part 42 of the first resonator 100 and the connection structure 300, i.e., both the metal layers are a metal layer where the second electrode 40 is arranged, the second electrode connection part 42 of the first resonator 100 may be directly connected to the electrical component 200 through the connection structure 300.

In a case that the metal layer of the electrical component 200 for connecting is different from the metal layer of the second electrode connection part 42 of the first resonator 100 and connection structure 300, the second electrode connection part 42 of the first resonator 100 may be directly connected to the connection structure 300, but a through hole is arranged running through the metal layer of the connection structure 300 and the metal layer of the electrical component 200. The through hole is provided with a connection member, so that the metal layer of the connection structure 300 is connected to the metal layer of the electrical component 200 through the connection member.

In an embodiment of the present disclosure, as shown in Figure 16, the second electrode connection part 42 of the first resonator 100 is connected to the electrical component 200 through the connection structure 300 and a connection member 400. A through hole is arranged running through the piezoelectric layer 30, and the connection member 400 is located in the through hole and connected to the electrical component 200. In the first direction Z, the connection member 400 further extends from the through hole to the upper surface of the piezoelectric layer 30.

For example, as shown in Figure 16, the electrical component 200 is the resonator identical to the first resonator 100. Where, a second electrode 40 of one resonator is connected to a first electrode 20 of the other resonator, and a piezoelectric layer 30 of one resonator and a piezoelectric layer 30 of the other resonator are grown in a same layer. The second electrode 40 of one resonator is grown along the second gap K2 and the piezoelectric layer 30 and is connected to the first electrode 20 at an opening of the piezoelectric layer 30 of the other resonator.

For example, in a case that the electrical component is a capacitor, an inductor, or a pad, the connection member 400 may be directly connected to a same metal layer of the first electrode 20 of the first resonator 100 at the bottom of the through hole of the piezoelectric layer 30. Alternatively, the connection member 400 may extend from the through hole of the piezoelectric layer 30 to the upper surface of the piezoelectric layer, and then connected to the metal layer of the electrical component 200 for connecting. The connection manner of the connection member 400 is not limited in the present disclosure, which depends on the actual situation.

A method for manufacturing a bulk acoustic resonator is further provided according to an embodiment of the present disclosure. The method includes steps S100 to S500 as follows.

In step S100, a substrate 10 with a first sacrificial layer 11 or a Bragg reflector is provided.

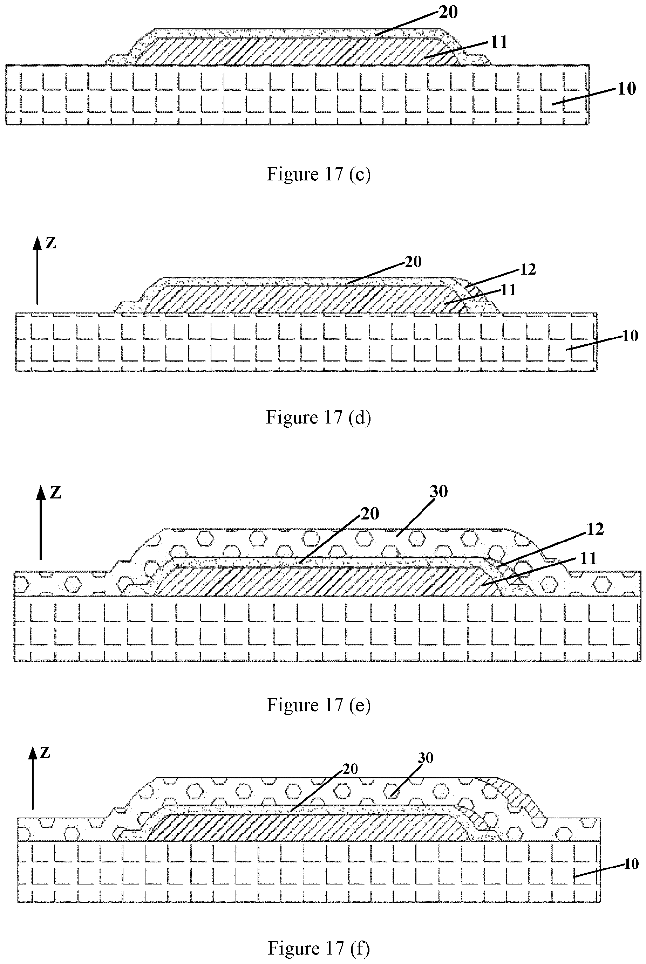

As an example, firstly, as shown in Figure 17(a), the substrate 10 is provided. The substrate 10 may be made of materials, such as silicon (Si), silicon dioxide (SiO₂), gallium arsenide (GaAs), glass or ceramic materials.

Secondly, as shown in Figure 17(b), the first sacrificial layer 11 is directly grown on the substrate 10, and the first sacrificial layer 11 is etched to form a first sacrificial layer pattern, to obtain the substrate 10 with the first sacrificial layer 11. Subsequently, a first electrode 20, a piezoelectric layer 30, and a second electrode 40 are sequentially grown on a surface of the substrate 10 and a surface of the first sacrificial layer 11. After each film layer is fabricated, the first sacrificial layer 11 is removed to form an aboveground cavity.

Alternatively, the substrate is etched to form a cavity, the cavity is filled with the first sacrificial layer, and the surface of the substrate is ground. Subsequently, the first electrode 20, the piezoelectric layer 30, and the second electrode 40 are sequentially grown on the surface of the substrate. After each film layer is fabricated, the first sacrificial layer 11 is removed to form an underground cavity.

Alternatively, a Bragg reflector formed by alternately stacking low acoustic impedance layers and high acoustic impedance layers may be directly grown on the substrate or after the substrate is etched to form the cavity, and the pattern may be etched to obtain a substrate with the Bragg reflector. The Bragg reflector is used as an acoustic reflection component.

In step S200, the first electrode 20 is formed on the substrate 10, so that the first sacrificial layer 11 or the Bragg reflector is arranged between the substrate 10 and the first electrode 20.

In an embodiment, based on the pre-fabricated aboveground cavity shown in Figure 17(b), as shown in Figure 16(c), the first electrode 20 is grown on the surface of the substrate 10 and the surface of the first sacrificial layer 11. The first electrode 20 covers the first sacrificial layer 11, and a terminal end of the first electrode 20 is etched to be inclined to reduce a morphological change of the piezoelectric layer. The first electrode is made of a single metal or alloy, such as Ti, Al, Cu, Au, Mo, Ru, Ni, W, Pt or TiN.

In step S300, the piezoelectric layer 30 is formed on a side of the first electrode 20 away from the substrate 10, and a second sacrificial layer 12 is formed between the first electrode 20 and the piezoelectric layer 30.

Based on a structure of the bulk acoustic resonator shown in Figure 17(c), as shown in Figure 16(d), the second sacrificial layer 12 is deposited at an edge of the first electrode 20 and then etched to form a first gap pattern. The second sacrificial layer 12 coincides with an inclined turning point at the edge of the first electrode 20, i.e., the first electrode 20 protrudes upwards on the surface of the substrate 10. A protrusion of the first electrode 20 includes a first sloping region with an inclined angle relative to the surface of the substrate 10. An initial end of the second sacrificial layer 12 coincides with an initial end of the first sloping region. A terminal end of the second sacrificial layer 12 is located beyond a terminal end of the first sloping region. In addition, in the first direction Z, an upper surface of the second sacrificial layer 12 is not higher than an upper surface of the first electrode 20. The first direction Z is perpendicular to a plane where the substrate 10 is located.

Next, as shown in Figure 17(e), the piezoelectric layer 30 is grown on the surface of the first electrode 20 and the surface of the second sacrificial layer 12. The piezoelectric layer 30 has a constant thickness in the horizontal direction. The piezoelectric layer is made of a material such as AlN, PZT, ZnO, LiTaO₃, or LiNbO₃, etc.

In step S400, the second electrode 40 is formed on a side of the piezoelectric layer 30 away from the substrate 10, and a third sacrificial layer 13 is formed between the piezoelectric layer 30 and the second electrode 40.

In an embodiment, based on a structure of the bulk acoustic resonator shown in Figure 17(e), as shown in Figure 16(f), the third sacrificial layer 13 is deposited on the surface of the piezoelectric layer 30 and then etched to form a second gap pattern. An upper surface of the second gap pattern is higher or not higher than the upper surface of the part of the piezoelectric layer 30 within the effective resonance region.

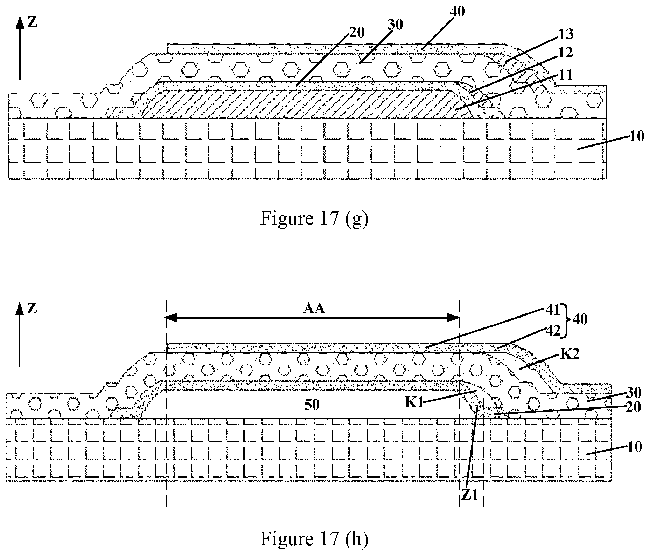

As shown in Figure 17(g), the second electrode 40 is grown on the surface of the piezoelectric layer 30 and the surface of the third sacrificial layer 13. The second electrode is made of a single metal or alloy such as Ti, Al, Cu, Au, Mo, Ru, Ni, W, Pt, or TiN.

In step S500, the first sacrificial layer 11 is released to form a cavity used as the acoustic reflection component 50. Alternatively, the Bragg reflector is directly used as the acoustic reflection component 50. The second sacrificial layer 12 and the third sacrificial layer 13 are released to form a first gap K1 between the first electrode 20 and the piezoelectric layer 30, and form a second gap K2 between the second electrode connection part 42 of the second electrode 40 in addition to a part of the second electrode located within an effective resonance region and the piezoelectric layer 30.

Where, an overlapping part of the acoustic reflection component 50, the first electrode 20, the piezoelectric layer 30, and the second electrode 40 is the effective resonance region AA. An initial end of the first gap K1 coincides with a terminal end of the effective resonance region AA. In a first direction Z, an upper surface of the first gap K1 is not higher than an upper surface of a part of the first electrode 20 within the effective resonance region AA. A terminal end of the second gap K2 is located at an outer side of a terminal end of the first electrode 20. A projection of the second gap K2 in the first direction Z overlaps with a projection of the first gap K1 in the first direction Z. The first direction Z is perpendicular to the plane where the substrate 10 is located.

As shown in Figure 17(h), the first sacrificial layer 11 is released to form the aboveground cavity, and the second sacrificial layer 12 and the third sacrificial layer 12 are released to form the first gap K1 and the second gap K2, respectively. Ultimately, the bulk acoustic resonator in a double-layer gap structure is obtained as shown in Figure 17(h).

Figures 17(a) to 17(h) are schematic diagrams of a formation process of a double-layer gap structure of a bulk acoustic resonator in which an acoustic reflection component is an aboveground cavity. Based on this, those skilled in the art may manufacture the bulk acoustic resonator with the double-layer gap structure according to any one of the foregoing embodiments.

A filter is further provided according to an embodiment of the present disclosure. The filter includes the bulk acoustic resonator according to any one of the foregoing embodiments, or the resonator assembly according to any one of the foregoing embodiments.

An electronic device is further provided according to an embodiment of the present disclosure. The electronic device includes the bulk acoustic resonator according to any one of the foregoing embodiments, or the resonator assembly according to any one of the foregoing embodiments.

The bulk acoustic resonator and the resonator assembly are described in detail in the foregoing embodiments, which are not repeated herein.

Based on the above description, the bulk acoustic wave resonator, related devices that include the resonator assembly, the filter, and the electronic device, and a method for manufacturing a bulk acoustic wave resonator are provided according to embodiments of the present disclosure. The bulk acoustic wave resonator includes the substrate and the acoustic reflection component 50, the first electrode 20, the piezoelectric layer 30, and the second electrode 40 that are sequentially stacked on the substrate. The first gap is provided between the first electrode and the piezoelectric layer. The second gap is provided between the piezoelectric layer and the second electrode connection part of the second electrode in addition to the part located within the effective resonance region. The initial end of the first gap coincides with the terminal end of the effective resonance region. The terminal end of the second gap is located at an outer side of the terminal end of the first electrode. The first gap overlaps with the second gap in the direction perpendicular to a plane where the substrate is located. Such double-layer gap structure can reduce the parasitic oscillation in the non-effective resonance region, reflect the transverse waves, reduce the leakage of the transverse wave, improve the Q factor of the device. In addition, the electrode layers and the piezoelectric layer are more stable due to the mutual support at the two gaps.

The various parts in this specification are described in a parallel and progressive manner, with each part focusing on the differences from other parts. The same and similar parts may be referred to each other.

According to the above description of the disclosed embodiments, features provided in the embodiments in this specification may be replaced or combined with each other, so that those skilled in the art can implement or use the present disclosure. Various modifications made to these embodiments may be obvious to those skilled in the art, and the general principle defined herein may be implemented in other embodiments without departing from the spirit or scope of the present disclosure. Hence, the present disclosure is not limited to the embodiments described herein but conforms to a widest scope in accordance with principles and novel features disclosed in the present disclosure.

## Claims

1. A bulk acoustic resonator, comprising:
a substrate; and
a first electrode, a piezoelectric layer, and a second electrode that are sequentially stacked on a surface of the substrate;
wherein the piezoelectric layer extends beyond a terminal end of the first electrode, an acoustic reflection component is arranged between the first electrode and the substrate, and an overlapping part of the acoustic reflection component, the first electrode, the piezoelectric layer, and the second electrode is configured as an effective resonance region;
a first gap is provided between the first electrode and the piezoelectric layer, and an initial end of the first gap coincides with a terminal end of the effective resonance region; in a first direction, an upper surface of the first gap is not higher than an upper surface of a part of the first electrode within the effective resonance region; in addition to a part of the second electrode located within the effective resonance region, the second electrode further comprises a second electrode connection part, a second gap is provided between the second electrode connection part and the piezoelectric layer, a terminal end of the second gap is located at outer side of the terminal end of the first electrode, a projection of the second gap in the first direction interlaces and overlaps with a projection of the first gap in the first direction, and the first direction is perpendicular to a plane where the substrate is located.

2. The bulk acoustic resonator according to claim 1, wherein a width of an overlapping region between the projection of the first gap in the first direction and the projection of the second gap in the first direction is greater than or equal to half of a width of the first gap.

3. The bulk acoustic resonator according to claim 1, wherein in the first direction, a distance from an upper end to a lower end of a cross-section of the second gap ranges from 10nm to 200nm, including endpoints.

4. The bulk acoustic resonator according to claim 1, wherein in the first direction, a distance from an upper end to a lower end of a cross-section of the second gap ranges from 30nm to 50nm, including endpoints.

5. The bulk acoustic resonator according to claim 1, wherein the upper surface of the first gap in the first direction is arc-shaped, inclined, stepped, or horizontal.

6. The bulk acoustic resonator according to claim 1, wherein the first electrode protrudes upwards from the surface of the substrate, the acoustic reflection component is formed between a protrusion of the first electrode and the surface of the substrate, and the protrusion of the first electrode comprises a first sloping region with an inclined angle relative to the surface of the substrate; and
the initial end of the first gap coincides with an initial end of the first sloping region, and the terminal end of the first gap extends beyond a terminal end of the first sloping region.

7. The bulk acoustic resonator according to claim 1, wherein the first electrode comprises a first thinning region, a thickness of the first thinning region is less than a thickness of the part of the first electrode within the effective resonance region, the first gap is formed between at least a part of the first thinning region and the piezoelectric layer, and an initial end of the first thinning region coincides with the initial end of the first gap.

8. The bulk acoustic resonator according to claim 7, wherein an upper surface of the first thinning region in the first direction is arc-shaped, inclined, stepped, or groove-shaped.

9. The bulk acoustic resonator according to claim 7, wherein a terminal end of the first thinning region coincides with the terminal end of the first electrode; or the terminal end of the first thinning region is located at an inner side of the terminal end of the first electrode.

10. The bulk acoustic resonator according to claim 7, wherein a terminal end of the first thinning region is located at an inner side of the terminal end of the first electrode, and a horizontal distance between the initial end of the first thinning region and the terminal end of the first electrode is no more than 3µm.

11. The bulk acoustic resonator according to claim 1, further comprising:
at least one third gap, provided between the first electrode and the piezoelectric layer, wherein the at least one third gap is located on one or more sides of the effective resonance region away from the first gap, and a terminal end of the second electrode away from the second electrode connection part does not extend beyond a terminal end of the third gap; and
in the first direction, an upper surface of the third gap is not higher than the upper surface of the part of the first electrode within the effective resonance region.

12. The bulk acoustic resonator according to claim 11, wherein the first electrode comprises a second thinning region, and a thickness of the second thinning region is less than a thickness of the part of the first electrode within the effective resonance region, so that the third gap is formed between the second thinning region and the piezoelectric layer.

13. The bulk acoustic resonator according to claim 11, wherein the third gap is formed by the first gap surrounding the effective resonance region, and the third gap is in communication with the first gap; or
the third gap is not in communication with the first gap.

14. The bulk acoustic resonator according to claim 1, wherein a recess is formed by the first electrode recessing towards the acoustic reflection component, and the first gap is formed between the recess and the piezoelectric layer.

15. The bulk acoustic resonator according to claim 14, wherein a sidewall of the recess is directly in contact with a sidewall of the acoustic reflection component; or a space is provided between the sidewall of the recess and the sidewall of the acoustic reflection component.

16. The bulk acoustic resonator according to claim 14, wherein a horizontal distance between the initial end of the first gap and a terminal end of the acoustic reflection component is no more than 3µm.

17. The bulk acoustic resonator according to claim 1, wherein an upper surface of the second gap in the first direction is arc-shaped, inclined, stepped, arch-shaped or groove-shaped.

18. The bulk acoustic resonator according to claim 1, wherein the piezoelectric layer has a constant thickness in the first direction.

19. A resonator assembly, at least comprising:
a first resonator, wherein the first resonator is the bulk acoustic resonator according to any one of claims 1 to 18,
an electrical component; and
a connection structure, wherein two ends of the connection structure are connected to a second electrode connection part of the first resonator and the electrical component, respectively.

20. The resonator assembly according to claim 19, wherein in the first direction, an upper surface of the connection structure aligns with an upper surface of a part of the second electrode within an effective resonance region of the first resonator, and a fourth gap is provided between the connection structure and the piezoelectric layer.

21. The resonator assembly according to claim 19, wherein the second electrode connection part of the first resonator is connected to the electrical component through the connection structure and a connection member, the piezoelectric layer is provided with a through hole running through the piezoelectric layer, and the connection member is located in the through hole and connected to the electrical component; in the first direction, the connection member further extends from the through hole to the upper surface of the piezoelectric layer.

22. The resonator assembly according to claim 19, wherein the electrical component comprises a resonator, an inductor, a capacitor, or a pad.

23. A method for manufacturing a bulk acoustic resonator, comprising:
providing a substrate with a first sacrificial layer or a Bragg reflector;
forming a first electrode on the substrate, so that the first sacrificial layer or the Bragg reflector is arranged between the substrate and the first electrode;
forming a piezoelectric layer on a side of the first electrode away from the substrate, and forming a second sacrificial layer between the first electrode and the piezoelectric layer;
forming a second electrode on a side of the piezoelectric layer away from the substrate, and forming a third sacrificial layer between the piezoelectric layer and the second electrode; and
releasing the first sacrificial layer to form a cavity, which serves as an acoustic reflection component, or directly using the Bragg reflector as the acoustic reflection component, and releasing the second sacrificial layer and the third sacrificial layer, to form a first gap between the first electrode and the piezoelectric layer, and form a second gap between the piezoelectric layer and a second electrode connection part of the second electrode in addition to a part of the second electrode located within an effective resonance region;
wherein an overlapping part of the acoustic reflection component, the first electrode, the piezoelectric layer, and the second electrode is configured as the effective resonance region, an initial end of the first gap coincides with a terminal end of the effective resonance region; in a first direction, an upper surface of the first gap is not higher than an upper surface of a part of the first electrode within the effective resonance region, a terminal end of the second gap is located at an outer side of a terminal end of the first electrode, a projection of the second gap in the first direction interlaces and overlaps with a projection of the first gap in the first direction; and the first direction is perpendicular to the plane where the substrate is located.

24. A filter, comprising the bulk acoustic resonator according to any one of claims 1 to 18, or the resonator assembly according to any one of claims 19 to 22.

25. An electronic device, comprising the bulk acoustic resonator according to any one of claims 1 to 18, or the resonator assembly according to any one of claims 19 to 22.
